# EUROPEAN PATENT SPECIFICATION

(11) **EP 2 692 899 B1**
(45) Date of publication and mention of the grant of the patent: **19.04.2017**
(21) Application number: 12765033.1
(22) Date of filing: 28.03.2012
(51) Int. Cl.: C23C 16/54, B65H 20/02, B65H 20/06, B65H 20/20, C23C 16/455

(54) **ROLL TO ROLL ATOMIC LAYER DEPOSITION (ALD)**
ROLLE-ZU-ROLLE ATOMLAGENBESCHICHTUNG (ALD)
DÉPÔT DE COUCHE ATOMIQUE (ALD) DU TYPE ROULEAU À ROULEAU

(30) Priority: 29.03.2011 JP 2011072141; 27.09.2011 JP 2011210048
(43) Date of publication of application: 05.02.2014
(73) Proprietor: Toppan Printing Co., Ltd., Tokyo 110-8560 (JP)
(72) Inventor: KANO, Mitsuru, Tokyo 110-8560 (JP); SASAKI Yasuhiro, Tokyo 110-8560 (JP)
(74) Representative: Andrews, Timothy Stephen
(86) International application number: PCT/JP2012/058164
(87) International publication number: WO 2012/133541

(56) References cited:
- WO-A1-2007/112370
- WO-A2-2005/001157
- WO-A2-2010/065966
- GB-A- 1 238 937
- JP-A- 3 022 221
- JP-A- 9 057 873
- JP-A- 2002 255 367
- JP-A- 2004 141 810
- JP-A- 2007 160 199
- JP-A- 2009 256 709
- JP-A- 2010 052 872

## Description

### TECHNICAL FIELD

The present invention relates to a roll-to-roll thin film coating machine forming a film using atomic layer deposition by continuously depositing a stack of atomic layers on a surface of a windable flexible base member.

### BACKGROUND ART

Conventionally, techniques are known of winding a long length of rolled windable substrate such as a paper, a plastic film, or the like in a vacuum and sequentially forming metal, metal oxide, or the like thereon by a film coating method such as evaporation coating, sputtering, or the like.

Such techniques are utilized for methods of manufacturing metallic luster films used for purls, gas barrier films for food packaging, electrodes for film capacitors, optical films such as anti-reflective film, or the like.

In recent years, as an intended use of gas barrier films, demand for commercialization of a transparent gas barrier film with high-level gas barrier properties such that the moisture vapor transmission rate thereof is 10⁻⁶ g/(m²·day) has been increasing in order for development of an organic EL display of a flexible base member, organic EL illumination, organic solar cells which use organic semiconductors.

To meet this need, a winding apparatus using atomic layer deposition has been studied.

The atomic layer deposition is known as a method of forming a dense thin film.

From the viewpoint of advantage of the characteristics of the atomic layer deposition, the atomic layer deposition is used when an insulating film is formed in DRAMs or a TFTs.

Conventionally, a deposition step of a thin film is carried out by batch processing, and an apparatus have been developed which processes a plurality of Si wafers at the same time for improvement of productivity, however, there is a limit to the productivity.

Additionally, such a batch processing apparatus cannot continuously form a film on a windable base member.

In order to solve the problem, apparatuses disclosed by Patent Documents 1 and 2 have been proposed.

Patent Documents 1 and 2 show a technique of successively forming a thin film by atomic layer deposition.

In the process of depositing a stack of atomic layers, the one cyclic operation of atomic layer deposition processes including a step of adsorbing first precursors onto a surface of the base member, a step of purging excessive first precursors, a step of reacting the first precursors and second precursors by exposing the first precursors to the second precursors, and a step of purging excessive second precursors are repeated multiple times.

Consequently, a thin film having a desired film thickness can be obtained.

Particularly, materials disclosed by, for example, Non-Patent Document 1 can be used as precursors.

Generally, a layer of approximately 0.01 nm to 0.2 nm, and approximately 0.1 nm is averagely formed in one cyclic operation of atomic layer deposition.

A desired film thickness varies depending on the intended use; in order to obtain a film having high-level gas barrier properties such that the moisture vapor transmission is 10⁻⁶ g/(m²·day) or less, in the case of aluminum oxide, it is generally known that 10 nm or more is necessary.

For this reason, it is necessary to perform a commonly-used one cyclic operation of atomic layer deposition a hundred times in order to obtain an aluminum oxide layer having the film thickness of 10 nm.

On the other hand, Patent Document 3 discloses a winding-up atomic layer deposition apparatus using a rotating drum.

In this apparatus, a stack of atomic layers is deposited on the base member while the base member is located on the rotating drum.

Moreover, Patent Document 4 discloses a winding-up atomic layer deposition apparatus using a spray manifold.

In this apparatus, a stack of atomic layers is deposited on the base member when the base member passes near the spray manifold.

### PRIOR ART DOCUMENTS

### PATENT DOCUMENTS

[Patent Document 1]PCT International Publication No. WO 07/112370
[Patent Document 2]Published Japanese Translation No. 2009-540122 of PCT International Publication
[Patent Document 3]Published Japanese Translation No. 2007-522344 of PCT International Publication
[Patent Document 4]Published Japanese Translation No. 2009-531548 of PCT International Publication

[Non-Patent Document 1]M. Ritala and another person, "Atomic Layer Deposition", Hand book of Thin Film Materials), the United States, Academic Press (AcademicPress), 2002, Vol. 1, Chapter 2, P. 103-159

### SUMMARY OF INVENTION

### PROBLEMS TO BE SOLVED BY THE INVENTION

However, the apparatuses disclosed in Patent Documents 1 and 2, the base member must pass through 100 sets of guide rollers in order to obtain an atomic-layer-deposited film having a film thickness of 10 nm.

This means that the atomic-layer-deposited film comes into contact with the guide rollers a hundred times.

There is a risk of damage to the atomic-layer-deposited film or generation of particles which are caused by friction or slipping in accordance with the contact of the atomic-layer-deposited film and the guide rollers.

Furthermore, there is a concern that the performance of the atomic-layer-deposited film deteriorates due to the damage to or the particles attached to the atomic-layer-deposited film.

The performance required for a gas barrier film used for a conventional food packaging is approximately 10⁻¹ g/(m²·day) in moisture vapor transmission rate, a small defect (scratches, pinholes, particle adhesion, or the like) is not a problem.

However, high performance such that the moisture vapor transmission rate is 10⁻⁶ g/(m²·day) or less is required for the intended use of organic EL displays, polymer solar cells, or organic semiconductors; even in a case where a small defect occurs in the aforementioned devices, inadmissible degradation in performance may occur.

There is a description of a transfer mechanism in the paragraph 0007 in Patent Document 1, however, it is only disclosed that, a guide that uses a roller and can support the base member when at least the transfer direction of the base member is converted is desirable.

Additionally, there is also a description of the transfer mechanism in the paragraph 0030, however, use of a roller as a transfer mechanism is only disclosed.

On the other hand, regarding a transfer method, Patent Document 2 discloses "Particularly, contact between a roller 22 and a base member 20 should be maintained to be minimized. This is carried out by mounting a spool-shaped ... on a large diameter portion of the roller 22" (paragraph 0013).

However, if the thickness of the base member is thin and the rigidity thereof is low, the base member comes into contact with not only the large diameter portion but also the entire spool configuration.

When an atomic-layer-deposited film comes into contact with a guide roller, a defect such as a microscopic pinhole or the like is generated on the atomic-layer-deposited film, and it is thereby impossible to obtain an intended performance.

Particularly, in the case where a low-rigidity base member such as a thin-plastic-film base member, a fabric, or the like is used, the contact between the roller and the base member cannot be prevented.

Moreover, in addition to the above description, Patent Document 2 discloses "Alternatively, a grasping portion, which sandwiches the base member 20 as the base member 20 is wound around each roller 22, can be provided at edge portions of the roller 22" (paragraph 0013), but does not specifically disclose an attachment method of the grasping portion and the roller edge portions, and a transfer mechanism.

Additionally, according to the devices disclosed in Patent Documents 3 and 4, a stack of atomic layers is not deposited on a surface of the base member which is in contact with a rotating drum or a surface of the base member which is not exposed to a spray manifold.

Therefore, Patent Documents 3 and 4 do not suggest problems such as damage to an atomic-layer-deposited film due to contact between a guide roller and a base member in a processing step which is caused by using the devices disclosed in Patent Documents 1 and 2, and a degradation in gas barrier properties due to the damage.

The invention was made in view of the above-described problems and has an object to provide an apparatus which can carry out the processing of continuously forming an atomic-layer-deposited film on a windable base member without allowing a guide roller to come into contact with the base member.

The invention has an object to provide an apparatus which prevents the base member from slipping at both end portions of the base member by use of a suction-type transfer mechanism without allowing a guide roller to come into contact with the base member with the exception of both end portions of the base member which are the portions to be held, and which can carry out the processing of stably and continuously forming an atomic-layer-deposited film on a windable base member.

The above-described suction type refers to as a system in which a plurality of holes are provided on a roller surface, and a film base member or the like is suctioned and attached to the roller surface by vacuuming the base member through the holes.

### MEANS FOR SOLVING THE PROBLEMS

In order to solve the above-described problems, the inventors invented a mechanism which can transfer a base member in a state where a film formation face thereof does not come into contact with a guide roller so that a dense atomic-layer-deposited film is not damaged by transfer of the base member.

A roll-to-roll thin film coating machine of a first aspect of the invention is an apparatus using atomic layer deposition,comprising: a first vacuum chamber into which a first precursor gas is introduced; a second vacuum chamber into which a second precursor gas is introduced; a third vacuum chamber into which a purge gas is introduced, the purge gas discharging the first precursors and the second precursors; and a plurality of transfer mechanisms transferring a windable base member through the first vacuum chamber, the second vacuum chamber, and the third vacuum chamber, the transfer mechanisms comprising a holding unit holding both end portions of the base member in a width direction thereof, the transfer mechanisms allowing the base member to alternately pass through the first vacuum chamber and the second vacuum chamber multiple times, thereby forming an atomic-layer-deposited film by depositing a stack of atomic layers on a surface of the base member, and each of the plurality of transfer mechanisms being independently provided in one of the first vacuum chamber, the second vacuum chamber and the third vacuum chamber.

In the roll-to-roll thin film coating machine of the first aspect of the invention, it is preferable that the holding unit be a sandwich-holding unit holding both end portions of the base member in the width direction thereof.

In the roll-to-roll thin film coating machine of the first aspect of the invention, it is preferable that the sandwich-holding unit sandwich both end portions of the base member in the width direction thereof between a plurality of sandwich-holding members.

In the roll-to-roll thin film coating machine of the first aspect of the invention, it is preferable that the sandwich-holding unit sandwich both end portions of the base member in the width direction thereof between continuous sandwich-holding members.

In the roll-to-roll thin film coating machine of the first aspect of the invention, it is preferable that the holding unit be a support unit supporting both end portions of the base member in the width direction thereof at one surface of the base member.

In the roll-to-roll thin film coating machine of the first aspect of the invention, it is preferable that the base member have a plurality of hole portions at both end portions in the width direction thereof, and the support unit support the hole portions by support portions having projecting portions fitting thereinto.

In the roll-to-roll thin film coating machine of the first aspect of the invention, it is preferable that the sandwich-holding unit sandwich both end portions of the base member in the width direction thereof at a top face and a back face between a plurality of rollers, and at least one of the rollers include a drive mechanism.

In the roll-to-roll thin film coating machine of the first aspect of the invention, it is preferable that, of the rollers, the roller holding the top face or the roller holding the back face include a mechanism capable of varying a rotation axis.

In the roll-to-roll thin film coating machine of the first aspect of the invention, it is preferable that the transfer mechanism be located so that a part constituting the transfer mechanism does not pass through the first vacuum chamber and the second vacuum chamber.

In the roll-to-roll thin film coating machine of the first aspect of the invention, it is preferable that a surface of the part constituting the transfer mechanism be formed of a material which is capable of preventing a first precursor gas or a second precursor gas from being chemisorbed thereonto.

It is preferable that the roll-to-roll thin film coating machine of the first aspect of the invention further include a protection-layer formation unit forming a protection layer on a surface of the atomic-layer-deposited film.

In order to solve the above-described problems, the inventors invented a mechanism which can transfer a base member while preventing the base member from slipping at both end portions of the base member in a state where a film formation face does not come into contact with a guide roller with the exception of both end portions of the base member which are the portions to be held so that a dense atomic-layer-deposited film is not damaged by transfer of the base member.

A roll-to-roll thin film coating machine of a second aspect of the invention is an apparatus using atomic layer deposition,comprising: a plurality of vacuum chambers into which two or more precursor gases are introduced; and a transfer mechanism used for transferring a base member to the vacuum chambers alternately multiple times, and comprising a holding unit holding both end portions of the base member in the width direction thereof by suction, wherein an atomic-layer-deposited film is formed by adsorbing precursors onto a surface of the base member, wherein the transfer mechanism is constituted of a plurality of rollers, holes are provided on surfaces of the rollers, and the holding unit holds the base member by suctioning the base member through the hole.

In the roll-to-roll thin film coating machine of the second aspect of the invention, it is preferable that the base member have a top face and a back face, the rollers be arranged at the top face and the back face, at least one of the rollers include a drive mechanism, holes be provided on a surface of at least one of the rollers arranged at the top face and the back face, and the holding unit hold the base member by suctioning the base member through the hole.

In the roll-to-roll thin film coating machine of the second aspect of the invention, it is preferable that the holding unit include a mechanism varying a rotation axis of any of rollers provided at the top face and the back face.

In the roll-to-roll thin film coating machine of the second aspect of the invention, it is preferable that the vacuum chambers include: a first vacuum chamber into which a first precursor gas is introduced; a second vacuum chamber into which a second precursor gas is introduced; and a third vacuum chamber into which a purge gas is introduced, the purge gas discharging the first precursors and the second precursors, wherein the transfer mechanism transfers the base member to the first vacuum chamber and, the second vacuum chamber, and the third vacuum chamber multiple times.

### Effects of the Invention

According to the roll-to-roll thin film coating machine of the first aspect of the invention, since the plurality of transfer mechanisms does not require the guide roller, there is not a concern that the atomic-layer-deposited film formed on the surface of the base member is damaged due to contact with the guide roller.

For this reason, by use of the roll-to-roll thin film coating machine of the invention, it is possible to continuously form an atomic-layer-deposited film without mechanical damage.

According to the roll-to-roll thin film coating machine of the second aspect of the invention, since the guide roller does not come into contact with the base member with the exception of both end portions of the base member which are the portions to be held, there is not a concern in damage to the atomic-layer-deposited film formed on the surface of the base member.

Additionally, transfer without slip can be realized by applying a mechanism which prevents a base member from slipping at both end portions of the base member.

As a result of using the roll-to-roll thin film coating machine of the invention, it is possible to continuously form an atomic-layer-deposited film without mechanical damage and slip through stable and clean transfer.

### BRIEF DESCRIPTION OF THE DRAWINGS

FIG. 1 is a schematic view showing a first roll-to-roll thin film coating machine.
FIG. 2 is a conceptual diagram showing a clipping-type holding transfer mechanism of the machine of FIG. 1.
FIG. 3 is a schematic view showing a second roll-to-roll thin film coating machine, which is an embodiment of the invention.
FIG. 4 is a conceptual diagram showing a belt-type holding transfer mechanism of the machine of FIG. 3.
FIG. 5 is a conceptual diagram showing a third roll-to-roll thin film coating machine.
FIG. 6 is a conceptual diagram showing a roller-type holding transfer mechanism of the machine of FIG. 5.
FIG. 7 is a conceptual diagram showing a fourth roll-to-roll thin film coating machine.
FIG. 8A is a conceptual diagram showing a roller-type holding transfer mechanism of the machine of FIG. 7.
FIG. 8B is a cross-sectional view showing the roller-type holding transfer mechanism of the machine of FIG. 7.
FIG. 8C is a plan view showing the roller-type holding transfer mechanism of the machine of FIG. 7.
FIG. 9 is a schematic view showing a fifth roll-to-roll thin film coating machine.
FIG. 10A is a conceptual diagram showing a sprocket-type supporting transfer mechanism of the machine of FIG. 9.
FIG. 10B is a cross-sectional view showing the sprocket-type supporting transfer mechanism of the machine of FIG. 9.
FIG. 11 is a schematic view showing a modified example of a roll-to-roll thin film coating machine.
FIG. 12A a conceptual diagram showing a guide rail provided in the roll-to-roll thin film coating machine of the invention.
FIG. 12B is a cross-sectional view showing the guide rail provided in the roll-to-roll thin film coating machine of the invention.
FIG. 13 is a schematic view showing a roll-to-roll thin film coating machine provided with a protection-layer formation unit.
FIG. 14 is a schematic view showing a roll-to-roll thin film coating machine of the Comparative Example.
FIG. 15A is a conceptual diagram showing a transfer mechanism of a roll-to-roll thin film coating machine of the Comparative Example.
FIG. 15B is a cross-sectional view showing a transfer mechanism of a roll-to-roll thin film coating machine of the Comparative Example.
FIG. 16 is a diagram showing a configuration of a sixth roll-to-roll thin film coating machine, which is an embodiment of the invention.
FIG. 17 is a conceptual diagram showing a suction-type transfer mechanism of the machine of FIG. 16.
FIG. 18 is a diagram showing a configuration of the roll-to-roll thin film coating machine of a modified example of the machine of FIG. 16.
FIG. 19A is a conceptual diagram showing a nip-roller-type holding transfer mechanism of the machine of FIG. 18.
FIG. 19B is a conceptual diagram showing a nip-roller-type holding transfer mechanism of the machine of FIG. 18.
FIG. 19C is a conceptual diagram showing a nip-roller-type holding transfer mechanism of the machine of FIG. 18.
FIG. 20A is a diagram showing a configuration of a guide rail of a modified example of a roll-to-roll thin film coating machine of the invention.
FIG. 20B is a diagram showing a configuration of a guide rail of a modified example of a roll-to-roll thin film coating machine of the invention.

### EMBODIMENTS FOR CARRYING OUT THE INVENTION

A roll-to-roll thin film coating machine of the invention is an apparatus forming a stack of atomic layers on a base member using atomic layer deposition.

The film formation apparatus includes: a first vacuum chamber into which a first precursor gas is introduced; a second vacuum chamber into which a second precursor gas is introduced; a third vacuum chamber into which a purge gas discharging excessive first precursors and second precursors is introduced; and a plurality of transfer mechanisms transferring a windable base member to each vacuum chamber.

Specifically, the plurality of transfer mechanisms are transfer mechanisms which can hold or support both end portions of the windable base member in the width direction thereof by use of a holding unit such as a plurality of clips, belts, sprockets, or the like.

By use of the transfer mechanisms, the windable base member can sequentially pass through each of the aforementioned vacuum chambers, and an atomic-layer-deposited film without mechanical damage is formed, while the surface of the windable base member, on which a film is to be coated in a film formation step, does not come into contact with machine parts disposed in the apparatus.

As a member or a device holding both end portions of the windable base member in the width direction thereof, a sandwich-holding unit using a plurality of clip-like sandwich-holding members and holding the end portions; a sandwich-holding unit using continuous sandwich-holding members such as a belt and holding the end portions; or a member, a device, or the like using a plurality of rollers and holding the top face and the back face of the end portion are adopted.

In other cases, as a member or a device holding both end portions of the windable base member in the width direction thereof, a support unit supporting one of surfaces of the end portion may be used instead of the above-described sandwich-holding units.

For example, a base member is preliminarily prepared which has a plurality of hole portions such as punched holes at both end portions in the width direction thereof, a support unit or the like is adopted which holds the end portions by use of support portions having a plurality of projecting portions fitting into the hole portions when the base member is transferred.

Hereinafter, specific embodiments of the invention will be described with reference to drawings.

Particularly, embodiments of the invention are not limited to the embodiments described below, modifications such as design change or the like may be made based on knowledge of one of ordinary skill in the art, the scope of embodiments of the invention includes embodiments to which such modifications are applied.

### First Roll-to-Roll Thin Film Coating Machine

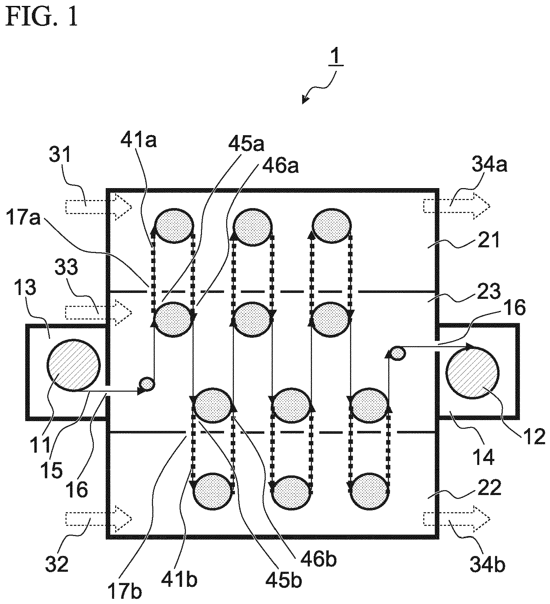

FIG. 1 shows a first roll-to-roll thin film coating machine.

The roll-to-roll thin film coating machine 1 includes: a first zone 21 serving as the first vacuum chamber into which a first precursor gas is introduced; a second zone 22 serving as the second vacuum chamber into which a second precursor gas is introduced, and a third zone 23 serving as a third vacuum chamber into which a purge gas is introduced.

The roll-to-roll thin film coating machine 1 includes: an unwinding roll 11 provided in an unwinding chamber 13; a rewinding roll 12 provided in a winding chamber 14; and transfer mechanisms 41a and 41b feeding the windable base member 15 from the unwinding roll 11 to the rewinding roll 12.

The transfer mechanisms 41a and 41b is a clipping-type holding transfer mechanism which transports the windable base member 15 while sandwiching both end portions of the windable base member 15 in the width direction thereof by clipping.

For continuously depositing a stack of atomic layers on the surface of the windable base member 15, the windable base member 15 is passed through the third zone 23, the first zone 21, the third zone 23, the second zone 22, and the third zone 23 in this order by use of the clipping-type holding transfer mechanisms 41a and 41b, as a result, one stack of atomic layers is thereby deposited on the base member.

In the roll-to-roll thin film coating machine, the film formation apparatus is designed so that a stack of atomic layers can be deposited on the surface of the base member 15 by the number of cycles required for obtaining a desired film thickness and so that the number of times for allowing the base member to pass through the aforementioned zones by the transfer mechanism becomes a predetermined number.

The windable base member 15 used is selected from flexible materials such as a plastic film, a plastic sheet, metal foil, a metal sheet, paper, a non-woven fabric, or the like.

The thickness of the windable base member 15 is not particularly limited, a base member having a thickness of 10 µm to 1000 µm can be used.

The windable base member 15 is unwound from the unwinding roll 11 and transferred to the third zone 23.

A partition plate is provided between the third zone 23 and the unwinding chamber 13 in which the unwinding roll 11 is placed, and a slot 16 necessary for allowing the windable base member 15 to pass therethrough is provided at the partition plate.

The windable base member 15 is transferred from the unwinding chamber 13 to the third zone 23 through the slot 16.

An inert gas serving as a purge gas is supplied to the third zone 23 (refer to reference numeral 33, flow of the purge gas).

As an inert gas, a gas optionally selected from nitrogen, helium, argon, or the like is used.

The end portions of the base member 15 in the width direction are sandwiched by clipping by use of the clipping-type holding transfer mechanism 41a at a clip-holding start position 45a in the third zone 23.

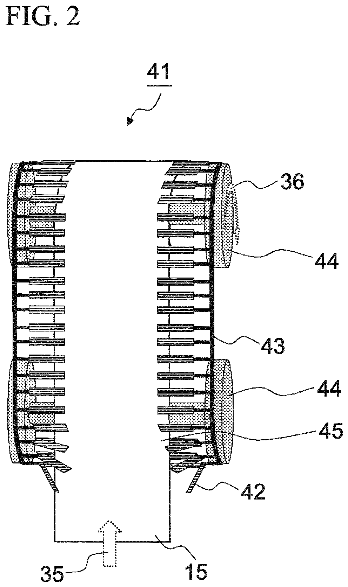

Here, FIG. 2 is a conceptual diagram showing the clipping-type holding transfer mechanism.

The clipping-type holding transfer mechanism 41 is provided with a plurality of clips 42 sandwiching both end portions of the windable base member 15 in the width direction thereof, a chain 43 coupled to the clips 42, and a drive sprocket 44 allowing the chain 43 to transfer in the transfer direction thereof.

The end portions of the windable base member 15 are sandwiched by the clips 42 at the clip-holding start position 45 of the clipping-type holding transfer mechanism 41.

A spring is provided at each clip 42 (not shown in the figure), the windable base member 15 whose both end portions are sandwiched is stretched in the width direction by suitable tension and maintained in a substantially planar shape without looseness during conveying.

The windable base member 15 is transferred in the transfer direction (refer to reference numeral 35, transfer direction of the windable base member) by rotation of driving rollers 44 (refer to reference numeral 36, rotational direction of the driving roller).

The material used to form the clips 42 is not particularly limited as long as a material is used therefor which can sandwich and hold both end portions of the windable base member 15 and can transfer the windable base member 15 while stretching it by adequate tension in the width direction.

In addition, an open-close mechanism of the clips 42, which is used when the windable base member 15 is sandwiched therebetween, may be a mechanism other than the above-described spring.

The windable base member 15 which is sandwiched by the clipping-type holding transfer mechanism 41a is transferred to the first zone 21 through slots 17a provided on a separating division wall disposed between the third zone 23 and the first zone 21.

Since first precursors are supplied to the first zone 21 (refer to reference numeral 31, flow of the first precursor gas), when the windable base member 15 passes through the first zone, the first precursors are adsorbed onto both faces of the windable base member 15.

Here, since only both end portions of the windable base member 15 are sandwiched by the clipping-type holding transfer mechanism 41a, both faces of the windable base member 15 onto which the first precursors are adsorbed does not come into contact with machine parts disposed in the apparatus.

The material constituting the first precursors is suitably selected depending on the intended deposition material.

In the case where the material which is to be deposited on the base member 105 is (intended deposition material) is aluminum oxide, for example, trimethylaluminium is used.

Moreover, as a material of the first precursors to be used, a material disclosed in Non-Patent Document 1 can be used.

The transportation speed of the windable base member 15 in the first zone 21 is calculated based on the saturation adsorption time and the pass-through distance so that the length of time at which the base member 15 passes through the first zone 21 is longer than the saturation adsorption time.

The windable base member 15 onto which the first precursors are saturate-adsorbed in the first zone 21 is re-transferred to the third zone 23 through another slot provided on a separating division wall disposed between the first zone 21 and the third zone 23.

Additionally, the gas present in the first zone 21 is discharged by a vacuum pump (refer to reference numeral 34a, discharge by the vacuum pump), the pressure inside the third zone 23 is maintained to be higher than the pressure inside the first zone 21.

Consequently, the first precursors which are introduced into the first zone 21 are maintained to be under conditions in which it is difficult to diffuse in the third zone 23.

It is preferable that difference in pressure between the first zone 21 and the third zone 23 at this time be approximately 0.01 Pa to 1 Pa.

The windable base member 15 which is transferred to the third zone 23 is released from the clips at a clip-holding completion position 46a.

Next, both end portions of the base member 15 in the width direction thereof are sandwiched by clipping by use of the clipping-type holding transfer mechanism 41b at a clip-holding start position 45b.

The windable base member 15 which is sandwiched by the clipping-type holding transfer mechanism 41b is transferred to the second zone 22 through slots 17b provided on a separating division wall disposed between the third zone 23 and the second zone 22.

Excessive first precursors which are adsorbed onto the windable base member 15 vaporizes, and it is purged while passing through the third zone 23.

The transportation speed of the windable base member 15 in the third zone 23 is calculated based on the pass-through distance so as to obtain a sufficient purging time.

Second precursors are supplied to the second zone 22 (refer to reference numeral 32, flow of the second precursor gas), a first-precursor-adsorbed product which is adsorbed onto both faces of the windable base member 15 reacts with the second precursors, and the intended material is generated while the windable base member 15 passes through the second zone 22.

Here, since only both end portions of the windable base member 15 are sandwiched by the clipping-type holding transfer mechanism 41b, when the first-precursor-adsorbed product reacts with the second precursors, neither of the faces of the windable base member 15 come into contact with machine parts disposed in the apparatus.

The material constituting the second precursors is suitably selected depending on the intended deposition material.

In the case of where, for example, the intended deposition material is aluminum oxide, water, ozone, or atomic oxygen is used.

Moreover, as a material of the second precursors to be used, a material disclosed in Non-Patent Document 1 can be used.

The transportation speed of the windable base member 15 in the second zone 22 is calculated based on the reaction time and the pass-through distance so that the length of time at which the base member 15 passes through the second zone 22 is longer than the reaction time.

After the first-precursor-adsorbed product reacts with the second precursors in the second zone 22, the windable base member 15 is re-transferred to the third zone 23 through another slot provided on a separating division wall disposed between the second zone 22 and the third zone 23.

Additionally, the gas present in the second zone 22 is discharged by a vacuum pump (refer to reference numeral 34b, discharge by the vacuum pump), and the pressure inside the third zone 23 is maintained to be higher than the pressure inside the second zone 22.

Consequently, the second precursors which are introduced into the second zone 22 are maintained to be under conditions in which it is difficult to diffuse in the third zone 23.

It is preferable that difference in pressure between the second zone 22 and the third zone 23 at this time be approximately 0.01 Pa to 1 Pa.

The windable base member 15 which is transferred to the third zone 23 is released from the clips at a clip-holding completion position 46b.

One cyclic operation of atomic layer deposition includes the above-described processes, and one stack of atomic layers is deposited on the base member by the processes.

It is possible to form an atomic-layer-deposited film having a desired film thickness on the surface of the windable base member 15 by repeating this cycle multiple times.

Additionally, when the aforementioned cycle is repeatedly carried out multiple times, the transportation speed of the windable base member 15 is set to be the lowest velocity in the transportation velocities, which are calculated based on the length of time required for exposing the base member 15 to the above-described first zone 21, the second zone 22, and the third zone 23 and the pass-through distance at which the base member 15 passes through the zones 21, 22, and 23.

After an atomic-layer-deposited film having a desired film thickness is formed on the surface of the windable base member 15 by repeating the aforementioned cycle multiple times, the windable base member 15 is wound around the rewinding roll 12.

A partition plate is provided between the third zone 23 and the winding chamber 14 in which the rewinding roll 12 is placed, and a slot 16 necessary for allowing the windable base member 15 to pass therethrough is provided at the partition plate.

The windable base member 15 is transferred from the third zone 23 to the winding chamber 14 through the slot 16 after film formation.

### Second Roll-to-Roll Thin Film Coating Machine

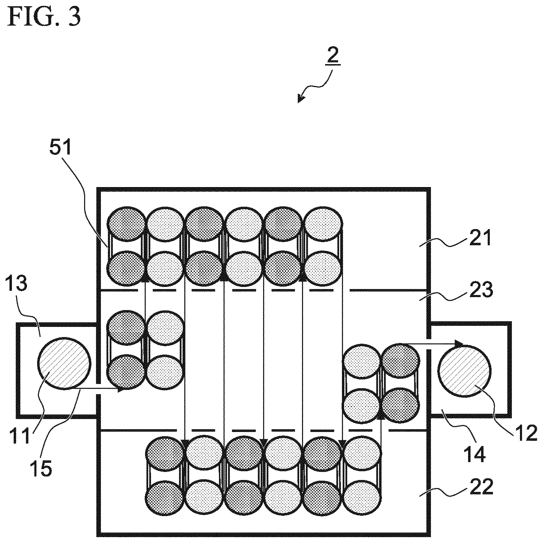

FIG. 3 shows a second roll-to-roll thin film coating machine, which is an embodiment of the invention.

Similar to the roll-to-roll thin film coating machine 1, the roll-to-roll thin film coating machine 2 of the invention includes: the first zone 21 serving as a first vacuum chamber into which a first precursor gas is introduced; the second zone 22 serving as a second vacuum chamber into which a second precursor gas is introduced; and the third zone 23 serving as a third vacuum chamber into which a purge gas is introduced.

The film formation apparatus 2 includes: the unwinding roll 11 provided in the unwinding chamber 13; the rewinding roll 12 provided in the winding chamber 14; and a transfer mechanism 51 feeding the windable base member 15 from the unwinding roll 11 to the rewinding roll 12.

In particular, the configuration of the roll-to-roll thin film coating machine 2 is the same as that of the roll-to-roll thin film coating machine 1 with the exception of the transfer mechanism 51.

The transfer mechanism 51 of this embodiment of the invention is a belt-type holding transfer mechanism which transports the windable base member 15 while sandwiching both end portions of the windable base member 15 in the width direction thereof by use of two belts.

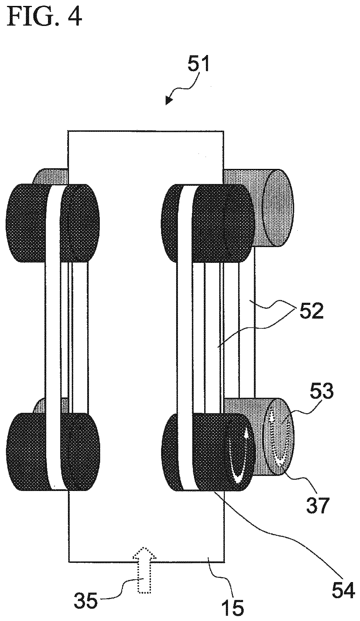

Here, FIG. 4 is a conceptual diagram showing the belt-type holding transfer mechanism of this embodiment of the invention.

The belt-type holding transfer mechanism 51 is provided with two belts 52 sandwiching the end portions of the windable base member 15 in the width direction thereof and pulleys 53 allowing the two belts 52 to feed in the transfer direction.

Both end portions of the windable base member 15 are sandwiched between the two belts 52 at a belt-holding start position 54 of the belt-type holding transfer mechanism 51.

The windable base member 15 whose both end portions are sandwiched is transferred (refer to reference numeral 35, transfer direction of the windable base member) in the transfer direction along with the rotation of the pulleys 53 (refer to reference numeral 37, rotational direction of the pulley).

The belt-type holding transfer mechanism 51 is disposed in each of the first zone 21, the second zone 22, and the third zone 23, and the base member 15 is transferred while the surface of the windable base member 15 does not come into contact with machine parts disposed in the apparatus.

The material used to form the two belts 52 is not particularly limited as long as a material is used therefor which can sandwich both end portions of the windable base member 15 and can feed the windable base member 15; for example, thermally-stable plastic such as aramid or the like or steel can be used.

### Third Roll-to-Roll Thin Film Coating Machine

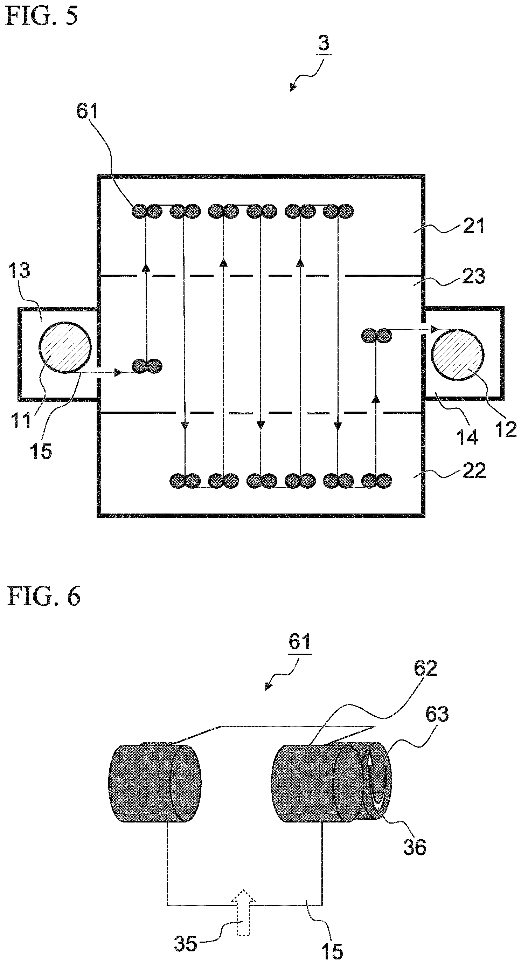

FIG. 5 shows a third roll-to-roll thin film coating machine.

Similar to the roll-to-roll thin film coating machine 1 o, the roll-to-roll thin film coating machine 3 includes: the first zone 21 serving as a first vacuum chamber into which a first precursor gas is introduced; the second zone 22 serving as a second vacuum chamber into which a second precursor gas is introduced; and the third zone 23 serving as a third vacuum chamber into which a purge gas is introduced.

The film formation apparatus 3 includes: the unwinding roll 11 provided in the unwinding chamber 13; the rewinding roll 12 provided in the winding chamber 14; and a transfer mechanism 61 feeding the windable base member 15 from the unwinding roll 11 to the rewinding roll 12.

In particular, the configuration of the roll-to-roll thin film coating machine 3 is the same as that of the roll-to-roll thin film coating machine 1 with the exception of the transfer mechanism 61.

The transfer mechanism 61 sandwiches the top face and the back face of both end portions of the windable base member 15 in the width direction thereof between two rollers different from each other, and sandwiches and transports the windable base member 15 by driving one of or both rollers.

The set of two rollers is disposed at not only one of the end portions of the base member 15 but also the other of the end portions similarly, transfers the windable base member 15 while sandwiching it therebetween.

A roller-type holding transfer mechanism is configured to carry out the above-described methods.

Here, FIG. 6 is a conceptual diagram showing a roller-type supporting transfer mechanism of the third machine.

The roller-holding transfer mechanism 61 uses two rollers 62 and 63, sandwiches both end portions of the windable base member 15 in the width direction thereof, and simultaneously transmits power thereto.

### Fourth Roll-to-Roll Thin Film Coating Machine

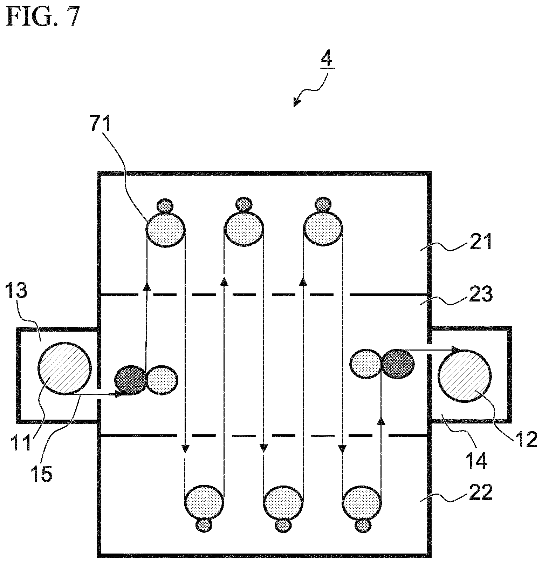

FIG. 7 shows a fourth roll-to-roll thin film coating machine.

Similar to the roll-to-roll thin film coating machine 1, the roll-to-roll thin film coating machine 4 o includes: the first zone 21 serving as a first vacuum chamber into which a first precursor gas is introduced; the second zone 22 serving as a second vacuum chamber into which a second precursor gas is introduced; and the third zone 23 serving as a third vacuum chamber into which a purge gas is introduced.

The film formation apparatus 4 includes: the unwinding roll 11 provided in the unwinding chamber 13; the rewinding roll 12 provided in the winding chamber 14; and a transfer mechanism 71 feeding the windable base member 15 from the unwinding roll 11 to the rewinding roll 12.

In particular, the configuration of the roll-to-roll thin film coating machine 4 is the same as that of the roll-to-roll thin film coating machine 1 with the exception of the transfer mechanism 71.

The transfer mechanism 71 sandwiches the top face and the back face of both end portions of the windable base member 15 in the width direction thereof between two rollers different from each other, and holds and transports the windable base member 15 by driving one of or both rollers.

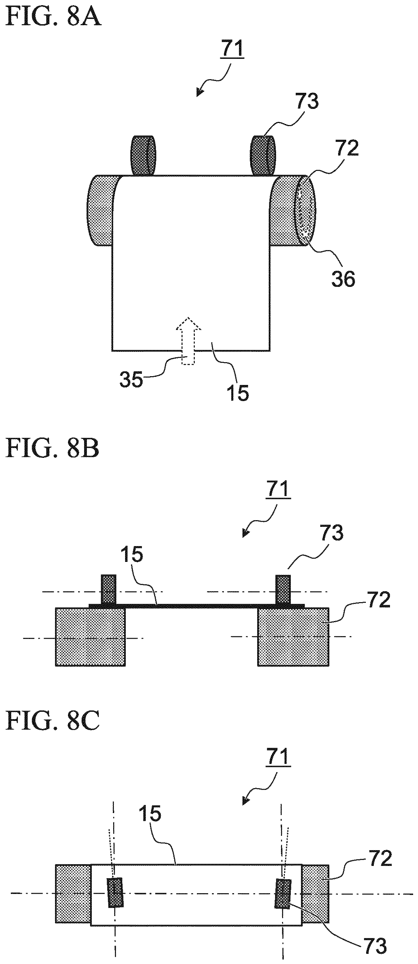

Here, FIGS. 8A and 8B are conceptual diagrams showing the roller-type holding transfer mechanism of the fourth machine.

Particularly, FIG. 8B is a cross-sectional view showing the roller-type holding transfer mechanism of the fourth machine.

The roller-type holding transfer mechanism 71 uses two rollers 72 and 73 different from each other, sandwiches the top face and the back face of both end portions of the windable base member 15 in the width direction thereof, and simultaneously transmits power to the base member 15.

Moreover FIG. 8C is a plan view showing the roller-type holding transfer mechanism of the fourth machine.

The roller-holding transfer mechanism 71 includes a mechanism which can vary the rotation axis of one roller 73 (first roller) of two rollers 72 and 73 holding the top face and the back face of both end portions of the windable base member 15 in the width direction thereof.

Specifically, the roller-holding transfer mechanism 71 can vary the rotation axis of the roller 73 so that the rotational axis direction of the roller 73 (first roller) is inclined with respect to the rotational axis direction of the other roller 72 (second roller).

The roller-holding transfer mechanism 71 varies the rotation axis of the roller 73 to allow the width of the base member 15 to spread in the direction of movement of the windable base member 15.

In other words, the rotation axis of the roller 73 is varied so that the rotational axis direction of the roller 73 is inclined with respect to the rotational axis direction of the roller 72.

Alternatively, the rotational axis direction of one of the rollers 73 arranged so as to face each other is inclined with respect to the rotational axis direction of the other roller.

Because of this, it is possible to control looseness of the windable base member 15.

In the case of providing the foregoing rotation axis variable mechanism in the roller-holding transfer mechanism 71, it is preferable that the diameter of the roller 73 whose rotation axis is variable be narrower than the diameter of the other roller 72 as shown in FIG. 8C.

Additionally, similar to the roller 73, the other roller 72 may be provided with a mechanism varying the axis of rotation thereof.

### Fifth Roll-to-Roll Thin Film Coating Machine

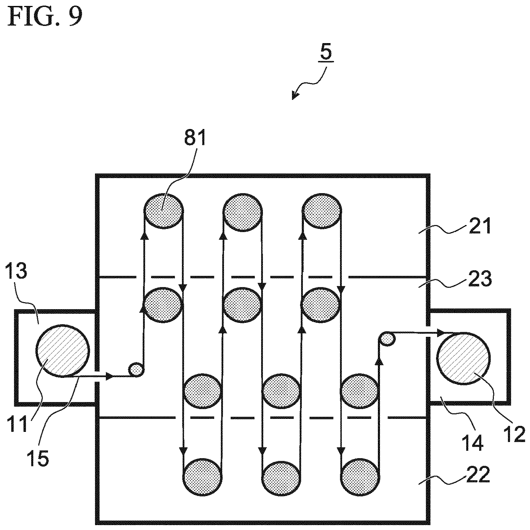

FIG. 9 shows a fifth roll-to-roll thin film coating machine.

Similar to the roll-to-roll thin film coating machine 1, the roll-to-roll thin film coating machine 5 includes: the first zone 21 serving as a first vacuum chamber into which a first precursor gas is introduced; the second zone 22 serving as a second vacuum chamber into which a second precursor gas is introduced; and the third zone 23 serving as a third vacuum chamber into which a purge gas is introduced.

The film formation apparatus 5 includes: the unwinding roll 11 provided in the unwinding chamber 13; the rewinding roll 12 provided in the winding chamber 14; and a transfer mechanism 81 feeding the windable base member 15 from the unwinding roll 11 to the rewinding roll 12.

In particular, the configuration of the roll-to-roll thin film coating machine 5 is the same as that of the roll-to-roll thin film coating machine 1 with the exception of the transfer mechanism 81.

Additionally, in the fifth machine, the windable base member 15 on which punched holes are preliminarily provided on both end portions in the width direction thereof is used, a stack of atomic layers is deposited on the base member 15.

The transfer mechanism 81 is a sprocket-type supporting transfer mechanism transfers the windable base member 15 with holding it by use of sprockets which are to be fitted into punched holes provided on the base member 15.

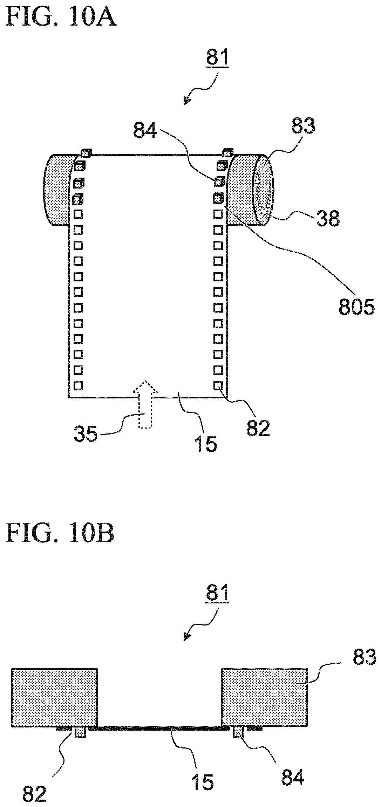

Here, FIGS. 10A and 10B are conceptual diagrams showing the sprocket-type supporting transfer mechanism of the fifth machine.

Particularly, FIG. 10B is a cross-sectional view showing the sprocket-type supporting transfer mechanism of the fifth machine.

The sprocket-type supporting transfer mechanism 81 uses the windable base member 15, on which a plurality of punched holes 82 are provided on both end portions in the width direction thereof, and is provided with a sprocket 83 which is to be fitted into the punched holes 82.

The punched holes 82 of the windable base member 15 are fitted into projecting portions 84 of the sprocket at a sprocket-holding start position 805 of the sprocket-type supporting transfer mechanism 81.

As the projecting portions 84 of the sprocket are fitted into the punched holes 82 of the windable base member 15, the windable base member 15 is transferred (refer to reference numeral 35, transfer direction of the windable base member) along with the rotation of the sprocket 83 (refer to reference numeral 38, rotational direction of the sprocket).

Particularly, since the windable base member 15 is fed while the projecting portions 84 of the sprocket are fitted into the punched holes 62, transfer with small displacement in the transfer direction of the windable base member 15 and the direction orthogonal to the transfer direction thereof can be realized.

In FIGS. 10A and 10B, a cross-sectional shape of the projecting portions 84 of the sprocket is rectangular, however, the shape can be suitably selected depending on the punched holes 82 of the windable base member 15.

### Modified Example

Modifications described below may be applied to the aforementioned first to fifth machines.

### Regarding Surface Of Parts Constituting the transfer mechanism

In the aforementioned transfer mechanisms, if parts constituting the transfer mechanism, such as a surface of the above-described clips, chain, belts, or the like, is made of a material including a functional group, for example, hydroxyl group, carboxyl group, or the like, to which the first precursor gas or the second precursor gas can be chemisorbed, the following problems may occur.

Particularly, when the transfer mechanism passes through a first vacuum chamber into which a first precursor gas is introduced and a second vacuum chamber into which a second precursor gas is introduced, an atomic-layer-deposited film is formed on the surface of the parts constituting the transfer mechanism.

In this case, an atomic-layer-deposited film which is thicker than the windable base member is formed on the aforementioned surface of the portions as a result of repeatedly passing through the first vacuum chamber and the second vacuum chamber.

The atomic-layer-deposited film brittle-fractures when it becomes a thick film, and causes extraneous materials (particles).

For this reason, in the case where the surface of the parts constituting the transfer mechanism is formed of a composition including a functional group, to which the first precursor gas or the second precursor gas can be chemisorbed, the transfer mechanism should be designed so as not to repeatedly pass through the first zone 21 and the second zone 22 as shown in FIG. 1.

Particularly, as shown in FIG. 3, the above-described problem is solved by the machines of the present invention by providing the transfer mechanism 51 in only the first zone 21, only the second zone 22, or only the third zone 23.

On the other hand, in the case where the surface of the parts constituting the transfer mechanism is formed of a composition not including a functional group, to which the first precursor gas or the second precursor gas can be chemisorbed, an atomic-layer-deposited film is not formed on the surface of the parts constituting the transfer mechanism even where the transfer mechanism repeatedly passes through the first vacuum chamber and the second vacuum chamber.

In the case where a coated film made of: fluorine-based polymers, for example, polytetrafluoroethylene or the like; or a coupling agent, for example, poly-para-xylene, octadecyltrichlorosilane, or the like, is formed on the surface of the parts constituting the transfer mechanism, an atomic-layer-deposited film is not formed thereon.

Therefore, in the case of using the transfer mechanism in which the surface of the parts constituting the transfer mechanism is made of a material such as the aforementioned coated film capable of preventing the first precursor gas or the second precursor gas from being chemisorbed thereonto, atomic layer deposition is not generated even where this passes repetitively through the first vacuum chamber and the second vacuum chamber.

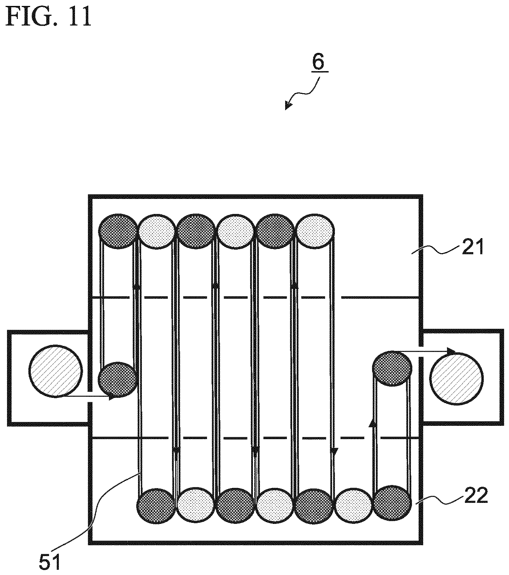

For example, in the case of using the transfer mechanism 51 which repeatedly passes through the first zone 21 and the second zone 22 as shown in the roll-to-roll thin film coating machine 6 in FIG. 11, it is necessary to use a transfer mechanism constituted of parts having surfaces on which the aforementioned coated film is formed.

However, when atomic layer deposition is carried out (in a step of depositing a stack of atomic layers on the base member), the parts constituting the transfer mechanism are oxidized due to using plasma active species or the like as precursors, and a functional group may be generated on the surface of the portions.

In this case, since an atomic-layer-deposited film is formed on the surface, use of the transfer mechanism repeatedly passing through the first zone 21 and the second zone 22 is undesirable.

### Regarding Position At which Transfer Mechanism Is Disposed

In the roll-to-roll thin film coating machine 1 , the transfer mechanism 41a passing through the first zone 21 and the third zone 23 and the transfer mechanism 41b passing through the second zone 22 and the third zone 23 are placed as shown in FIG. 1. In the machines of the present invention, the transfer mechanism is placed in only the first zone 21, only the second zone 22, or only the third zone 23 as shown in FIG. 3.

This may also be applied to the roll-to-roll thin film coating machine 3 of the third embodiment of the invention shown in FIG. 5.

### Regarding Guide Rails

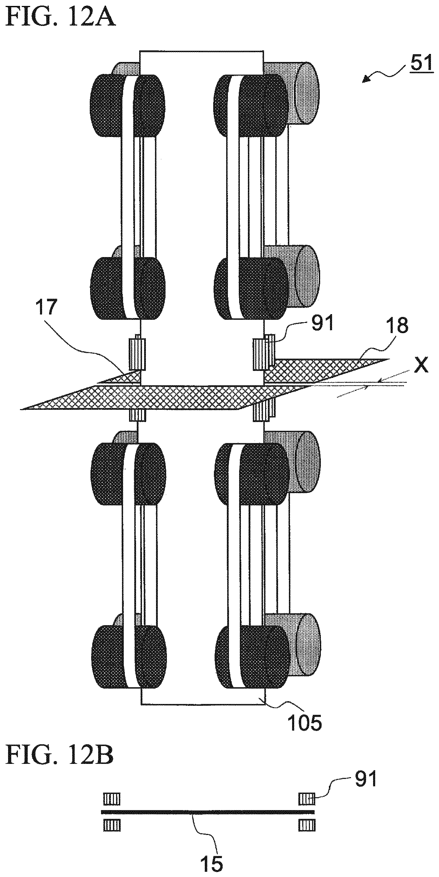

FIGS. 12A and 12B show guide rails which are used when the windable base member passes through a slot provided on a separating division wall disposed between a first zone and a third zone or a slot provided on a separating division wall disposed between a third zone and a second zone in the case of using the transfer mechanism (belt-type holding transfer mechanism) of the second machine.

In particular, FIG. 12B is a cross-sectional view showing of a guide rail.

Guide rails 91 are auxiliary parts used for upgrading degree of accuracy the position of the windable base member 15 passing through the slot 17 provided on the separating division wall 18 disposed between zones.

Since the windable base member 15 is fed to the slot 17 by use of the guide rails 91 with a high level of accuracy, the width (X) of the slot can be designed to be narrowed.

For this reason, generation of contamination caused by the precursors present in the first zone or the third zone and the purge gas present in the third zone can be reduced at a low level.

For example, in the case where the guide rails 91 are present, the width (X) of the slot can be set to be approximately 1 mm.

In contrast, in the case where the guide rails 91 are not provided, it is necessary to adjust the width (X) of the slot to be approximately 5 mm in consideration of stability in the position of the windable base member 15 during feeding.

It is preferable that the guide rails 91 be placed at the position close to the slot 17 so as to sandwich both end portions of the windable base member 15 therebetween as shown in FIG. 12B.

The positions at which the guide rails 91 are placed are adequately determined depending on the thickness of the windable base member 15, the transportation speed of the windable base member 15, or the like.

In other cases, though FIGS. 12A and 12B is applied to the belt-type holding transfer mechanism 51 which is the transfer mechanism of the second machine shown as an example, it may be applied to an apparatus in which, the clipping-type holding transfer mechanism which is the transfer mechanism of the first machineor the sprocket-type supporting transfer mechanism which is the transfer mechanism of the third machine is employed.

### Regarding Protection-layer Formation Unit

In the roll-to-roll thin film coating machine of the invention, an atomic-layer-deposited film is formed on both the upper side and the back side of the windable base member.

The windable base member having both faces on which the atomic-layer-deposited films are formed is finally rolled up in a rolled-shape in the apparatus.

At this time, the atomic-layer-deposited film formed on the top face of the windable base member is in contact with the atomic-layer-deposited film formed on the back side of the windable base member.

Consequently, when the atomic-layer-deposited films deposited on the top face and the back face of the windable base member come into contact with each other, there is also a concern that the atomic-layer-deposited film is mechanically damaged.

In this case, before winding the windable base member having both faces on which atomic-layer-deposited films are formed, it is preferable to coat (form) a protection layer on the base member.

As a method of coating the protection layer, for example, chemical vapor deposition method or the like is available.

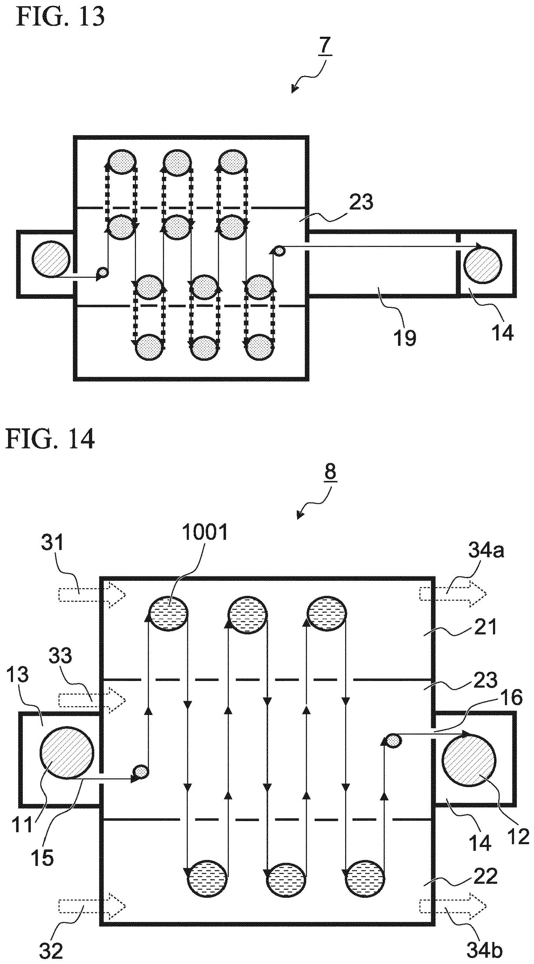

Specifically, a roll-to-roll thin film coating machine 7 shown in FIG. 13 includes a protection-layer coating chamber 19 serving as a protection-layer formation unit, which is between the third zone 23 and the winding chamber 14 and forms the protection layer.

In the protection-layer coating chamber 19, for example, tetraethoxysilane (TEOS) is used as a source material gas, in the chamber heated up to 120°C to which TEOS is supplied by a bubbling method using He gas, plasma-assisted decomposition reaction is generated and reacted with O₂ gas, and SiO₂ film with a thickness of 2 µm is thereby formed on the surface of the atomic-layer-deposited film.

Particularly, of the atomic-layer-deposited films formed on both faces of the windable base member, the protection layer is formed on at least one atomic-layer-deposited film, desirably, on both.

### Sixth Roll-to-Roll Thin Film Coating Machine

A roll-to-roll thin film coating machine of the invention is an apparatus forming an atomic-layer-deposited film on the surface of the windable base member by adsorb precursors thereonto using atomic layer deposition.

The film formation apparatus includes: a plurality of vacuum chambers into which two or more precursor gases are introduced (i.e., a first vacuum chamber into which a first precursor gas is introduced, a second vacuum chamber into which a second precursor gas is introduced, and a third vacuum chamber into which a purge gas discharging excessive first precursors and second precursors is introduced), and a transfer mechanism used for feeding the base member to the vacuum chambers alternately multiple times.

Specifically, the transfer mechanism includes a holding unit holding both end portions of the windable base member in the width direction thereof.

The holding unit uses a suction-type guide rollers which are constituted of a plurality of rollers and used for holding both end portions of the base member and for preventing it from slipping.

By use of the transfer mechanism, the windable base member can sequentially pass through each of the aforementioned vacuum chambers, while the surface of the windable base member, on which a film is to be coated in a film formation step, does not come into contact with machine parts disposed in the apparatus.

By means of this structure, mechanical damage to the base member is prevented, in addition, generation of particles caused by slip during the transfer of base member and unstable transfer are prevented, and an atomic-layer-deposited film with a high quality is formed on the base member.

As the holding unit holding both end portions of the windable base member in the width direction thereof, a guide roller including a suction-type mechanism in which a plurality of holes are formed and provided so that a roller suctions the base member, a member or a device holding the top face and the back face of the end portion by use of a plurality of rollers, or the like is adopted.

That is, the transfer mechanism is constituted of a plurality of rollers, and the holding unit holds the base member by suctioning the base member through the holes provided on each surface of the rollers.

Furthermore, the holding unit may be configured to hold the base member by the rollers placed on the top face and the back face of the base member so that at least one of rollers placed on the top face and the back face includes a drive mechanism.

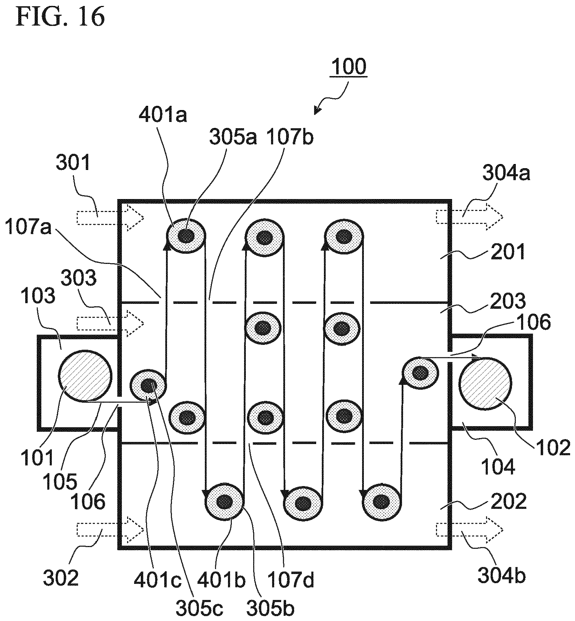

FIG. 16 shows a sixth roll-to-roll thin film coating machine, which is a machine of the invention.

The roll-to-roll thin film coating machine 100 of this embodiment of the invention includes: a first zone 201 serving as the first vacuum chamber into which a first precursor gas is introduced; a second zone 202 serving as the second vacuum chamber into which a second precursor gas is introduced, and a third zone 203 serving as a third vacuum chamber into which a purge gas is introduced.

The film formation apparatus 100 includes: an unwinding roll 101 provided in an unwinding chamber 103, a rewinding roll 102 provided in a winding chamber 104, and a suction-type transfer mechanism 401 (401 a, 401 b, 401c) including a suction mechanism which has a plurality of holes and is provided to feed a windable base member 105 from the unwinding roll 101 to the rewinding roll 102 while suctioning the windable base member.

The suction-type transfer mechanism 401 this embodiment of the invention conveys the windable base member 105 by use of guide rollers including the suction mechanisms (holding unit) which are provided to feed the windable base member 105 while suctioning both end portions in the width direction thereof.

For continuously depositing a stack of atomic layers on the surface of the windable base member 105, the windable base member 105 is passed through the third zone 203, the first zone 201, the third zone 203, the second zone 202, and the third zone 203 in this order by use of the suction-type transfer mechanism 401, as a result, one stack of atomic layers is thereby deposited on the base member.

In the roll-to-roll thin film coating machine of the invention, the film formation apparatus is designed so that a stack of atomic layers can be deposited on the surface of the base member 105 by the number of cycles required for obtaining a desired film thickness and so that the number of times for allowing the base member to pass through the aforementioned zones by the transfer mechanism becomes a predetermined number.

The windable base member 105 used for the invention is selected from flexible materials such as a plastic film, a plastic sheet, metal foil, a metal sheet, paper, a non-woven fabric, or the like.

The thickness of the windable base member 105 is not particularly limited, and a base member having a thickness of 10 µm to 1000 µm can be used.

The windable base member 105 is unwound from the unwinding roll 101 and transferred to the third zone 203.

A partition plate is provided between the unwinding chamber 103 in which the unwinding roll 101 is installed and the third zone 203, and a slot 106 necessary for passing the windable base member 105 therethrough is provided at the partition plate.

The windable base member 105 is transferred from the unwinding chamber 103 to the third zone 203 through the slot 106.

An inert gas serving as a purge gas is supplied to the third zone 203 (303).

As an inert gas, a gas optionally selected from nitrogen, helium, argon, or the like is used.

In order to hold only both end portions of the windable base member 105 in the third zone 203, the base member 105 is guided by the suction-type transfer mechanism 401c provided with the suction mechanism, and a state of stably conveying the base member 105 in the third zone 203 is also maintained.

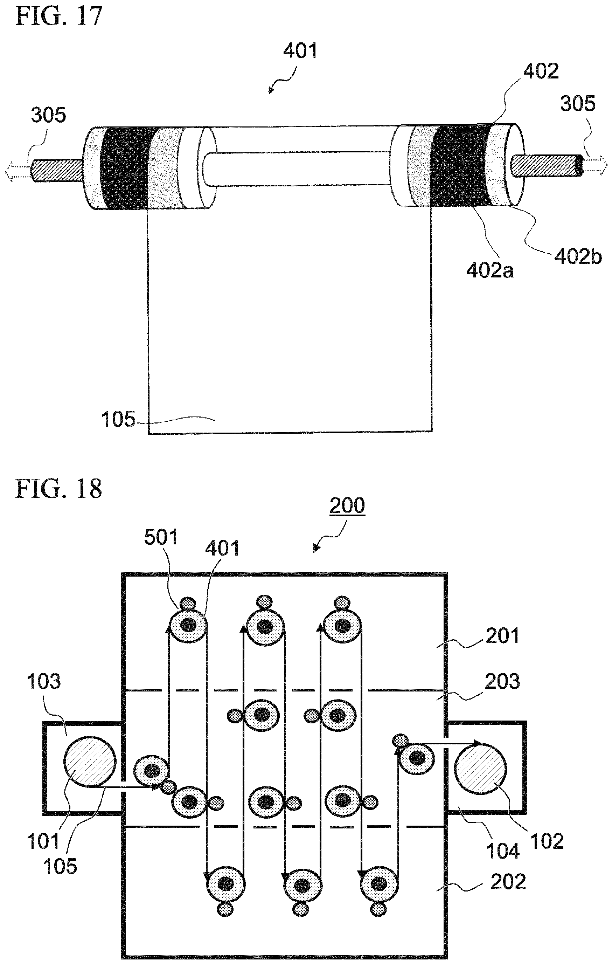

FIG. 17 is a conceptual diagram showing the suction-type transfer mechanism.

The suction-type transfer mechanism 401 of this embodiment of the invention is provided with the suction mechanism in which a plurality of holes is formed and provided to feed the windable base member 105 while suctioning both end portions thereof in the width direction.

The roller surface suctions the windable base member 105, and the suction-type roller 402 of the suction-type transfer mechanism 401 thereby holds the base member 105.

A vacuum pump is connected to each suction-type roller 402.

Suction is carried out through the holes by driving the vacuum pump (refer to reference numeral 305, pumping by suction-type roller), and the roller surface thereby suctions the windable base member 105.

The windable base member 105 held by the roller 402 is stretched with suitable tension in the width direction.

The base member 105 is maintained in a substantially planar shape without looseness during conveying.

The material used to form the suction-type roller 402 is not particularly limited as long as a material is used therefor which can hold both end portions of the windable base member 105 and feed the windable base member 105 while maintaining a suitable frictional force therebetween.

Furthermore, the suction-type roller 402 may be a mechanism allowing a suction portion 402a and a non-suction portion 402b to be simultaneously rotated, the suction portion 402a may be alone rotated, or the non-suction portion 402b may be a non-rotation roller.

Returning to explanation of FIG. 16, the windable base member 105 held by the suction-type transfer mechanism 401c is fed to the first zone 201 through slots 107a provided on a separating division wall disposed the third zone 203 and the first zone 201.

Since the first precursors are supplied to the first zone 201 (refer to reference numeral 301), the first precursors are adsorbed onto both faces of the windable base member 105 when the windable base member 105 passes through the first zone 201.

Here, since only both end portions of the windable base member 105 are held by the suction-type transfer mechanism 401a, both faces of the windable base member 105 onto which the first precursors are adsorbed does not come into contact with machine parts disposed in the apparatus.

The material constituting the first precursors is suitably selected depending on the intended deposition material.

In the case where the material which is to be deposited on the base member 105 is (intended deposition material) is aluminum oxide, for example, trimethylaluminium is used.

Moreover, as a material of the first precursors to be used, for example, a material disclosed in Non-Patent Document 1 can be used.

The transportation speed of the windable base member 105 in the first zone 201 is calculated based on the saturation adsorption time and the pass-through distance so that the length of time at which the base member 105 passes through the first zone 201 is longer than the saturation adsorption time.

The windable base member 105 onto which the first precursors are saturate-adsorbed in the first zone 201 is re-transferred to the third zone 203 through another slot 107b provided on a separating division wall disposed between the first zone 201 and the third zone 203.

Particularly, the gas present in the first zone 201 is discharged by a suction-type roller suction mechanism disposed in the first zone and connected to the vacuum pump (refer to reference numeral 305a, pumping by suction-type roller), and is discharged by a pumping mechanism (reference numeral 304a) which is connected to the first zone.

The pressure inside the first zone 201 is maintained by use of both pumping mechanisms.

Additionally, the pressure inside the third zone 203 is maintained to be higher than the pressure inside the first zone 201.

Consequently, the first precursors which are introduced into the first zone 201 are maintained to be under conditions in which it is difficult to diffuse in the third zone 203.

It is preferable that difference in pressure between the first zone 201 and the third zone 203 at this time be approximately 0.01 Pa to 1 Pa.

Next, the windable base member 105 is transferred to the second zone 202 through slots 107c provided on a separating division wall disposed between the third zone 203 and the second zone 202.

Excessive first precursors which are adsorbed onto the windable base member 105 vaporizes, and the base member 105 is purged while passing through the third zone 203.

At this time, the suction-type transfer mechanism 401 serving as a guide rollers at both end portions can be disposed inside the third zone 203 in order to stabilize a feeding state of the windable base member 105.

FIG. 16 shows a structure in which the suction-type transfer mechanism 401 is provided inside the third zone 203.

The transportation speed of the windable base member 105 in the third zone 203 is calculated based on the pass-through distance so as to obtain a sufficient purging time.

Second precursors are supplied to the second zone 202 (refer to reference numeral 302), a first-precursor-adsorbed product which is adsorbed onto both faces of the windable base member 105 reacts with the second precursors, and the intended material is generated while the windable base member 105 passes through the second zone 202.

Here, since only both end portions of the windable base member 105 are held by the suction-type transfer mechanism 401b, when the first-precursor-adsorbed product reacts with second precursors, both faces of the windable base member 105 does not come into contact with machine parts disposed in the apparatus.

The material constituting the second precursors is suitably selected depending on the intended deposition material.

In the case of where, for example, the intended deposition material is aluminum oxide, water, ozone, or atomic oxygen is used.

Moreover, as a material of the second precursors to be used, for example, a material disclosed in Non-Patent Document 1 can be used.

The transportation speed of the windable base member 105 in the second zone 202 is calculated based on the reaction time and the pass-through distance so that the length of time at which the base member 105 passes through the second zone 202 is longer than the reaction time.

After the first-precursor-adsorbed product reacts with the second precursors in the second zone 202, the windable base member 105 is re-transferred to the third zone 203 through another slot 107b provided on a separating division wall disposed between the second zone 202 and the third zone 203.

Particularly, the gas present in the second zone 202 is discharged by a suction-type roller suction mechanism disposed in the second zone and connected to the vacuum pump (refer to reference numeral 305b, pumping by suction-type roller), and is discharged by a pumping mechanism (reference numeral 304b) which is connected to the second zone.

The pressure inside the third zone 203 is maintained to be higher than the pressure inside the second zone 202 by use of both pumping mechanism.

Consequently, the second precursors which are introduced into the second zone 202 are maintained to be under conditions in which it is difficult to diffuse in the third zone 203.

It is preferable that difference in pressure between the second zone 202 and the third zone 203 at this time be approximately 0.01 Pa to 1 Pa.

One cyclic operation of atomic layer deposition includes the above-described processes, and one stack of atomic layers is deposited on the base member by the processes.

It is possible to form an atomic-layer-deposited film having a desired film thickness on the surface of the windable base member 105 by repeating this cycle multiple times.

Additionally, when the aforementioned cycle is repeatedly carried out multiple times, the transportation speed of the windable base member 105 is set to be the lowest velocity in the transportation velocities, which are calculated based on the length of time required for exposing the base member 105 to the above-described first zone 201, the second zone 202, and the third zone 203 and the pass-through distance at which the base member 105 passes through the zones 201, 202, and 203.

After an atomic-layer-deposited film having a desired film thickness is formed on the surface of the windable base member 105 by repeating the aforementioned cycle multiple times, the windable base member 105 is wound around the rewinding roll 102.

A partition plate is provided between the third zone 203 and the winding chamber 104 in which the rewinding roll 102 is placed, and a slot 106 necessary for allowing the windable base member 105 to pass therethrough is provided at the partition plate.

The windable base member 105 is transferred from the third zone 203 to the winding chamber 104 through the slot 106 after film formation.

### Modified Example

Modifications described below may be applied to the aforementioned sixthmachine.

### Regarding Nip Roller

FIG. 18 is a diagram showing a configuration a modified example of a roll-to-roll thin film coating machine of the sixth machine.

A roll-to-roll thin film coating machine 200 is provided with a nip-roller-type holding transfer mechanism 501 as shown in FIG. 18.

The nip-roller-type holding transfer mechanism 501 rectifies looseness of the base member 105 or corrects meandering by applying tension to the windable base member 105, that is, by pulling the base member 105 along the transfer direction.

As a result of using the nip-roller-type holding transfer mechanism 501 as shown in FIG. 18, further significant effect can be obtained.

In the nip-roller-type holding transfer mechanism 501, the top face and the back face of both end portions of the windable base member 105 in the width direction is sandwiched between two rollers different from each other, the windable base member 105 is sandwiched by driving one of or both rollers, and the base member 105 is thereby transferred.

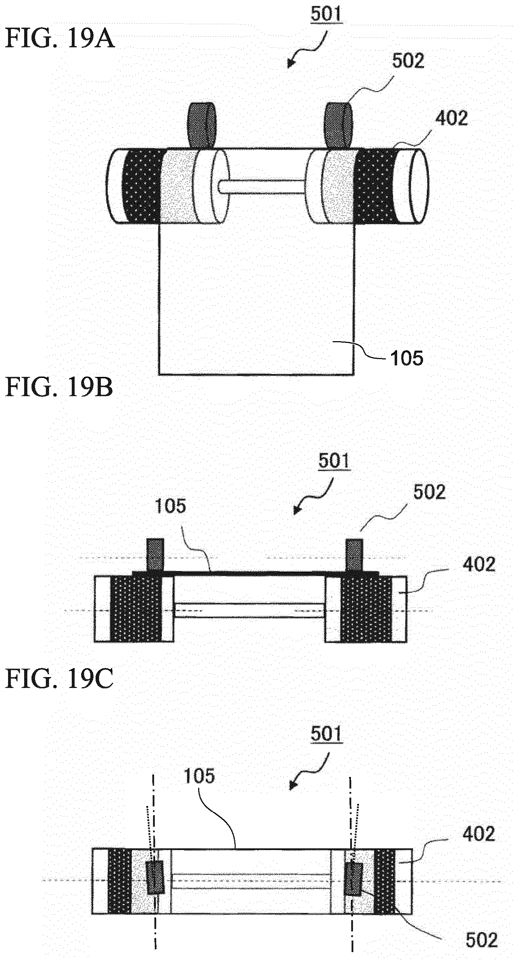

FIGS. 19A to 19C are conceptual diagrams showing modified examples of nip-roller-type holding transfer mechanisms, FIG. 19A is a perspective view showing the nip-roller-type holding transfer mechanism, FIG. 19B is a cross-sectional view showing the nip-roller-type holding transfer mechanism, and FIG. 19C is a plan view showing the nip-roller-type holding transfer mechanism.

The nip-roller-type holding transfer mechanism 501 is configured to include a structure in which nip rollers 502 is provided at the above-described suction-type roller 402 for the purpose of nipping.

The top face and the back face of both end portions of the windable base member 105 in the width direction are sandwiched by use of the nip-roller-type holding transfer mechanism 501, and power is simultaneously transmitted to the base member 105.

That is, the nip-roller-type holding transfer mechanism 501 is configured to sandwich the base member between the rollers placed on the top face and the back face of the base member so that at least one of rollers (the suction-type roller 402 in the sixthmachine) placed on the top face and the back face includes a drive mechanism.

Furthermore, as shown in FIG. 19C, the nip-roller-type holding transfer mechanism 501 includes two rollers 402 and 502 sandwiching the top face and the back face of both end portions of the windable base member 105 in the width direction thereof.

Moreover, the nip roller 502 (first roller) includes a mechanism capable of varying an axis of rotation thereof.

This means that, any of rollers (the nip roller 502) provided on the top face and the back face include a mechanism capable of changing a rotation axis thereof.

Specifically, the nip-roller-type holding transfer mechanism 501 can vary the rotation axis of the nip roller 502 (first roller) so that the rotational axis direction of the nip roller 502 is inclined with respect to the rotational axis direction of the suction-type roller 402 (second roller).

The nip-roller-type holding transfer mechanism 501 varies the rotation axis of the nip roller 502 to allow the width of the base member 105 to spread in the direction of movement of the windable base member 105.

In other words, the rotation axis of the nip roller 502 is varied so that the rotational axis direction of the nip roller 502 is inclined with respect to the rotational axis direction of the suction-type roller 402.

Alternatively, the rotational axis direction of one of the nip rollers 502 arranged so as to face each other is inclined with respect to the rotational axis direction of the other roller.

Because of this, it is possible to control looseness of the windable base member 105.

In the case of providing the foregoing rotation axis variable mechanism in the nip-roller-type holding transfer mechanism 501, it is preferable that the diameter of the nip roller 502 whose rotation axis is variable be narrower than the diameter of the other suction-type roller 402 as shown in FIG. 19C.

Additionally, similar to the nip roller 502, the suction-type roller 402 may be provided with a mechanism varying the axis of rotation thereof.

Rectification of looseness of the windable base member or correction of meandering thereof is controlled by adjusting the pressure at which the nip rollers 502 press onto the suction-type roller 402, the directions of the nip rollers 502, and the suction force of the suction-type roller 402.

Consequently, it is possible to realize stabilized traveling (feeding of the base member).

### Regarding Guide Rails

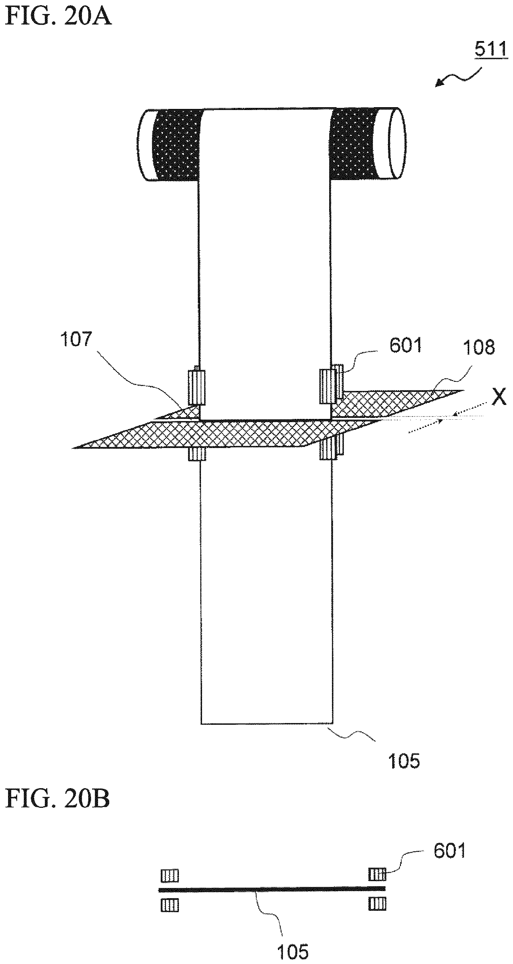

FIGS. 20A and 20B are diagrams showing a constitution of guide rails used in another modified example of a roll-to-roll thin film coating machine, FIG. 20A is a perspective view illustrating showing the position close to the slot when the guide rails are used, and FIG. 20B is a cross-sectional view illustrating the guide rails.

As shown in FIG. 20A, a roll-to-roll thin film coating machine 511 may include guide rails 601 which are located at the positions close to the slots 107 provided on a separating division wall disposed between the first zone 201 and the third zone 203 or the slots 107 provided on a separating division wall disposed between the third zone 203 and the second zone 202 and which are used when the windable base member 105 passes through.

The guide rails 601 are auxiliary parts used for upgrading degree of accuracy the position of the windable base member 105 passing through the slot 107 provided on the separating division wall 108 disposed between zones.

Since the windable base member 105 is fed to the slot 107 by use of the guide rails 601 with a high level of accuracy, the width (X) of the slot 107 can be designed to be narrowed.

Additionally, it is possible to omit a suction-type transfer mechanism 401 to be provided in the third zone 203, generation of contamination caused by the precursors present in the first zone 201 or the third zone 203 and the purge gas present in the third zone 203 can be reduced at a low level.

For example, in the case where the guide rails 601 are present, the width (X) of the slot can be set to be approximately 1 mm.

In contrast, in the case where the guide rails 601 are not provided, it is necessary to adjust the width (X) of the slot to be approximately 5 mm in consideration of stability in the position of the windable base member 105 during feeding.

It is preferable that the guide rails 601 be placed at the position close to the slot 107 so as to sandwich both end portions of the windable base member 105 therebetween as shown in FIG. 20B.

The positions at which the guide rails 601 are placed are adequately determined depending on the thickness of the windable base member 105, the transportation speed of the windable base member 105, or the like.

In the case where the windable base member 105 significantly unstably travels, since there is a concern that particles are generated caused by contact of the base member 105 and the guide rails 601 to each other, it is preferable to concomitantly use the suction-type transfer mechanism 401 in the third zone 203.

### Examples

### First Example

Next, a first Example roll-to-roll thin film coating machine shown in FIG. 1 will be described.

The roll-to-roll thin film coating machine 1 shown in FIG. 1 was used and a polyester film having a thickness of 100 µm was used as a windable base member 15.

The polyester film attached to the position of the unwinding roll 11 was fed to the third zone 23, both end portions of the base member 15 was sandwiched by clipping at the clip-holding start position 45a by use of the clipping-type holding transfer mechanism 41a in the third zone 23, and the base member 15 was transferred to the first zone 21.

Nitrogen gas used as a carrier gas and trimethylaluminium used as a first precursor were introduced into the first zone 21.

The flow rate of gasses were adjusted so that the internal pressure of the first zone 21 discharged by a dry vacuum pump (decompression) becomes roughly 50 Pa.

Trimethylaluminium was saturate-adsorbed onto both faces of the polyester film while being fed to the inside of the first zone 21 by use of the clipping-type holding transfer mechanism 41a.

The polyester film having both faces onto which trimethylaluminium was saturate-adsorbed was re-fed to the third zone 23.

Nitrogen gas was introduced into the third zone 23 as an inert gas.

The flow rate of the gas was adjusted so that the internal pressure of the third zone 23 becomes roughly 50.5 Pa.

Excessive trimethylaluminium was purged while being fed to the inside of the third zone 23.

After purging was fully carried out, both end portions the polyester film is sandwiched by clipping at the clip-holding start position 45b by use of the clipping-type holding transfer mechanism 41b in the third zone 23, and it was transferred to the second zone 22.

Nitrogen gas used as a carrier gas and ion-exchanged water used as a second precursor were introduced into the second zone 22.

The flow rate of gasses were adjusted so that the internal pressure of the second zone 22 discharged by a dry vacuum pump (decompression) becomes roughly 50 Pa.

Trimethylaluminium of both faces of the polyester film reacted with the ion-exchanged water and one stack of atomic layers was deposited on the base member while being fed to the inside of the second zone 22 by use of the clipping-type holding transfer mechanism 41b.

Particularly, the transportation speed of polyester film was determined by a required purging time in the third zone 23.

Moreover, all temperatures in the first zone 21, the second zone 22, and the third zone 23 were maintained to be 90°C.

In addition, as the roll-to-roll thin film coating machine 1 shown in FIG. 1, an apparatus is illustrated in which three-cyclic operations of atomic layer deposition were carried out in one time feeding, but as a practical matter, an apparatus which can perform a hundred-cyclic operations was prepared, a hundred-cyclic operations of atomic layer deposition was carried out.

As a result, the thickness of an aluminum oxide coating formed on the polyester film was 10 nm.

Furthermore, as a result of observing damages of the surface by use of an electron microscope, damage to the surface of the aluminum oxide coating was not recognized.

### Comparative Example

Deposition of aluminum oxide was carried out by use of the roll-to-roll thin film coating machine shown in FIG. 14.

A basic configuration of a roll-to-roll thin film coating machine 8 was the same as that of the roll-to-roll thin film coating machine 1 shown in FIG. 1, a transfer mechanism of the Comparative Example is different from the transfer mechanisms 41a and 41b of the roll-to-roll thin film coating machine 1 and was provided with the transfer mechanism 1001 using guide rollers.

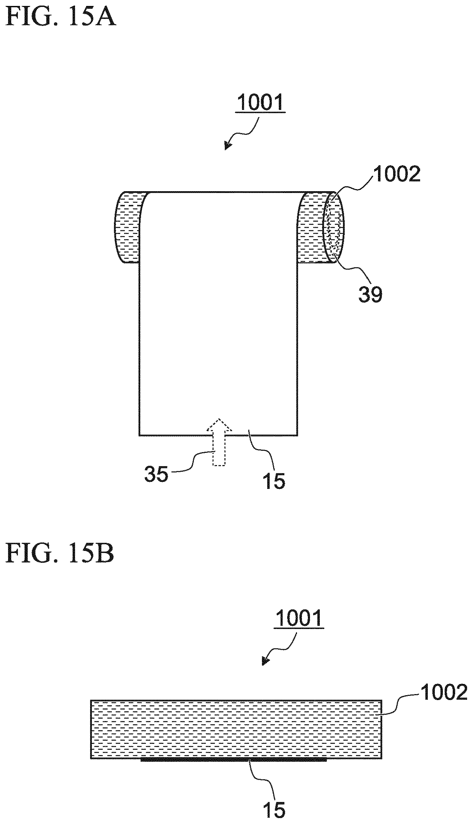

As shown in FIGS. 15A and 15B, the windable base member 15 was fed transferred by use of guide rollers 1002 of the guide-roller-type supporting transfer mechanism 1001.

Therefore, the guide-roller-type supporting transfer mechanism 1001 was provided with a transfer mechanism in which the windable base member 15 becomes in contact with two guide rollers for each one cyclic operation of atomic layer deposition.

The Comparative Example is different from first Example in the sense of the aforementioned transfer method, but in the Comparative Example, atomic layer deposition for an aluminum oxide was carried out under the conditions shown in first Example.

In addition, an apparatus is illustrated in FIG. 14, in which three-cyclic operations of atomic layer deposition were carried out in one time feeding, but as a practical matter, an apparatus which can perform a hundred-cyclic operations was prepared, a hundred-cyclic operations of atomic layer deposition was carried out.

As a result, the thickness of an aluminum oxide coating formed on the polyester film was 10 nm.

Furthermore, as a result of observing damages of the surface by use of an electron microscope, damage was recognized.

### Second Example

Next, a second Example roll-to-roll thin film coating machine shown in FIG. 16 will be described.

The roll-to-roll thin film coating machine 100 shown in FIG. 16 was used and a polyester film having a thickness of 100 µm was used as a windable base member 105.

The polyester film attached to the position of the unwinding roll 101 was fed to the third zone 203 and fed to the first zone 201 by use of the suction-type transfer mechanism 401c in the third zone 203.

Nitrogen gas used as a carrier gas and trimethylaluminium used as a first precursor were introduced into the first zone 201.

The displacement 305a discharged by the suction-type roller, the displacement 304a discharged from the first zone, and the flow rate 301 of the gas supplied to the first zone were adjusted so that the internal pressure of the first zone 201 becomes roughly 50 Pa.

Trimethylaluminium was saturate-adsorbed onto both faces of the polyester film while being fed to the inside of the first zone 201 by use of the suction-type transfer mechanism 401a.

The polyester film having both faces onto which trimethylaluminium was saturate-adsorbed was re-fed to the third zone 203.

Nitrogen gas was introduced into the third zone 203 as an inert gas.

The displacement 305c discharged by the suction-type roller and the flow rate 303 of the gas were adjusted so that the internal pressure of the third zone 203 becomes roughly 50.5 Pa.

Excessive trimethylaluminium was purged while the polyester film is fed to the inside of the third zone 203.

After purging was fully carried out, the polyester film was transferred to the second zone 202.

Nitrogen gas used as a carrier gas and ion-exchanged water used as a second precursor were introduced into the second zone 202.

The displacement 305b discharged by the suction-type roller, the displacement 304b discharged from the second zone, and the flow rate 302 of the gas supplied to the second zone were adjusted so that the internal pressure of the second zone 202 becomes roughly 50 Pa.

Trimethylaluminium of both faces of the polyester film reacted with the ion-exchanged water and one stack of atomic layers was deposited on the base member while being fed to the inside of the second zone 202 by use of the suction-type transfer mechanism 401b.

Particularly, the transportation speed of polyester film was determined by a required purging time in the third zone 203.

Moreover, all temperatures in the first zone 201, the second zone 202, and the third zone 203 were maintained to be 90°C.

In addition, as the roll-to-roll thin film coating machine 100 shown in FIG. 16, an apparatus is illustrated in which three-cyclic operations of atomic layer deposition were carried out in one time feeding, but as a practical matter, an apparatus which can perform a hundred-cyclic operations was prepared, a hundred-cyclic operations of atomic layer deposition was carried out.

As a result, the thickness of an aluminum oxide coating formed on the polyester film was 10 nm.

Furthermore, as a result of observing damages of the surface including the end portions by use of an electron microscope, damage to the surface of the aluminum oxide coating was not recognized.

### Comparative Example

The roll-to-roll thin film coating machine 100 was used shown in FIG. 16, and a polyester film having a thickness of 100 µm was used as the windable base member 105.

The polyester film attached to the position of the unwinding roll 101 was fed to the third zone 203 and fed to the first zone 201 by use of the suction-type transfer mechanism 401c in the third zone 203.

At this time, discharge 305c by the suction-type roller in a film formation apparatus of the Comparative Example was not carried out.

Nitrogen gas used as a carrier gas and trimethylaluminium used as a first precursor were introduced into the first zone 201.

The displacement 304a discharged from the first zone and the flow rate 301 of the gas were adjusted so that the internal pressure of the first zone 201 becomes roughly 50 Pa.

At this time, discharge 305a by the suction-type roller was not carried out.

Saturation adsorption of trimethylaluminium onto both faces of the polyester film was carried out while being fed to the inside of the first zone 201 by the suction-type transfer mechanism 401a.

The polyester film having both faces onto which trimethylaluminium was saturate-adsorbed was re-fed to the third zone 203.

Nitrogen gas was introduced into the third zone 203 as an inert gas.

The flow rate 303 of the gas was adjusted so that the internal pressure of the third zone 203 becomes roughly 50.5 Pa.

Excessive trimethylaluminium was purged while being fed to the inside of the third zone 203.

After purging was fully carried out, the polyester film was transferred to the second zone 202.

Nitrogen gas used as a carrier gas and ion-exchanged water used as a second precursor were introduced into the second zone 202.

The displacement 304b discharged from the second zone and the flow rate 302 of the gas were adjusted so that the internal pressure of the second zone 202 becomes roughly 50 Pa.

Trimethylaluminium of both faces of the polyester film reacted with the ion-exchanged water and one stack of atomic layers was deposited on the base member while being fed to the inside of the second zone 202 by use of the suction-type transfer mechanism 401b.

At this time, discharge 305c was not carried out by the suction-type roller.

Particularly, the transportation speed of polyester film was determined by a required purging time in the third zone 203.

Moreover, all temperatures in the first zone 201, the second zone 202, and the third zone 203 were maintained to be 90°C.

In addition, as the roll-to-roll thin film coating machine 100 shown in FIG. 16, an apparatus is illustrated in which three-cyclic operations of atomic layer deposition were carried out in one time feeding, but as a practical matter, an apparatus which can perform a hundred-cyclic operations was prepared, a hundred-cyclic operations of atomic layer deposition was carried out.

As a result, the formed aluminum oxide coating was 10 nm in thickness.

Furthermore, as a result of observing damages of the surface including the end portions by use of an electron microscope, damage to the surface of the aluminum oxide coating formed at a roller-non-contact portion located at the center of the windable base member 105 in the width direction thereof was not recognized, however, fine scratches at a roller-contact portion of the base member 105 were confirmed.

### Industrial Applicability

Since the roll-to-roll apparatus of the invention can continuously form a film on a windable base member, it is applicable to methods of manufacturing metallic luster films used for purls, gas barrier films for food packaging, electrodes for film capacitors, optical films such as anti-reflective film, or the like.

## Claims

1. A roll-to-roll thin film coating machine (1, 2, 3, 4, 5, 6, 7, 8) comprising:
a first vacuum chamber (21) into which a first precursor gas is introduced;
a second vacuum chamber (22) into which a second precursor gas is introduced;
a third vacuum chamber (23) into which a purge gas is introduced, the purge gas discharging the first precursors and the second precursors; and
a plurality of transfer mechanisms (51, 61, 71, 81, 501, 1001) transferring a windable base member (15) through the first vacuum chamber (21), the second vacuum chamber (22), and the third vacuum chamber (23), the transfer mechanism (51, 61, 71, 81, 501, 1001) comprising a holding unit (42, 43, 52, 62, 63, 72, 73) holding both end portions of the base member (15) in a width direction thereof, the transfer mechanisms (51, 61, 71, 81, 501, 1001) allowing the base member (15) to alternately pass through the first vacuum chamber (21) and the second vacuum chamber (22) multiple times, thereby forming an atomic-layer-deposited film by depositing a stack of atomic layers on a surface of the base member(15), and each of the plurality of transfer mechanism (51, 61, 71, 81, 501, 1001) being independently provided in one of the first vacuum chamber (21), the second vacuum chamber (22) and the third vacuum chamber (23).

2. The roll-to-roll thin film coating machine (1, 2, 3, 4, 5, 6, 7, 8) according to claim 1, wherein
the holding unit (42, 43, 52, 62, 63, 72, 73) is a sandwich-holding unit holding both end portions of the base member (15) in the width direction thereof.

3. The roll-to-roll thin film coating machine (1, 2, 3, 4, 5, 6, 7, 8) according to claim 2, wherein
the sandwich-holding unit sandwiches both end portions of the base member (15) in the width direction thereof between a plurality of sandwich-holding members or between continuous sandwich-holding members.

4. The roll-to-roll thin film coating machine (1, 2, 3, 4, 5, 6, 7, 8) according to claim 2, wherein
the holding unit (42, 43, 52, 62, 63, 72, 73) is a support unit supporting both end portions of the base member (15) in the width direction thereof at one surface of the base member (15).

5. The roll-to-roll thin film coating machine (1, 2, 3, 4, 5, 6, 7, 8) according to claim 4, wherein
the base member (15) has a plurality of hole portions at both end portions in the width direction thereof, and
the support unit supports the hole portions by support portions having projecting portions fitting thereinto.

6. The roll-to-roll thin film coating machine (1, 2, 3, 4, 5, 6, 7, 8) according to claim 2, wherein
the sandwich-holding unit sandwiches both end portions of the base member (15) in the width direction thereof at a top face and a back face between a plurality of rollers, and
at least one of the rollers comprises a drive mechanism.

7. The roll-to-roll thin film coating machine (1, 2, 3, 4, 5, 6, 7, 8) according to claim 6, wherein
of the rollers, the roller holding the top face or the roller holding the back face (502) comprises a mechanism capable of varying a rotation axis (501).

8. The roll-to-roll thin film coating machine (1, 2, 3, 4, 5, 6, 7, 8) according to any one of claims 1 to 7, wherein
the transfer mechanism (51, 61, 71, 81, 501, 1001) is located so that a part constituting the transfer mechanism (51, 61, 71, 81, 501, 1001) does not pass through the first vacuum chamber (21) and the second vacuum chamber (22).

9. The roll-to-roll thin film coating machine (1, 2, 3, 4, 5, 6, 7, 8) according to any one of claims 1 to 7, wherein
a surface of the part constituting the transfer mechanism (51, 61, 71, 81, 501, 1001) is formed of a material which is capable of preventing a first precursor gas or a second precursor gas from being chemisorbed thereonto.

10. The roll-to-roll thin film coating machine (1, 2, 3, 4, 5, 6, 7, 8) according to any one of claims 1 to 9, further comprising:
a protection-layer formation unit forming a protection layer on a surface of the atomic-layer-deposited film.

11. A roll-to-roll thin film coating machine (1, 2, 3, 4, 5, 6, 7, 8) comprising:
a plurality of vacuum chambers (21, 22, 23) into which two or more precursor gases are introduced; and
a transfer mechanism (51, 61, 71, 81, 501, 1001) used for transferring a base member (15) to the vacuum chambers (21, 22, 23) alternately multiple times, and comprising a holding unit (42, 43, 52, 62, 63, 72, 73) holding both end portions of the base member in the width direction thereof by suction, wherein
an atomic-layer-deposited film is formed by adsorbing precursors onto a surface of the base member, wherein
the transfer mechanism (51, 61, 71, 81, 501, 1001) is constituted of a plurality of rollers,
holes are provided on surfaces of the rollers, and
the holding unit (42, 43, 52, 62, 63, 72, 73) holds the base member (15) by suctioning the base member (15) through the hole.

12. The roll-to-roll thin film coating machine (1, 2, 3, 4, 5, 6, 7, 8) according to claim 11, wherein
the base member (15) has a top face and a back face,
the rollers are arranged at the top face and the back face,
at least one of the rollers comprises a drive mechanism,
holes are provided on a surface of at least one of the rollers arranged at the top face and the back face, and
the holding unit (42, 43, 52, 62, 63, 72, 73) holds the base member (15) by suctioning the base member through the hole.

13. The roll-to-roll thin film coating machine (1, 2, 3,4, 5, 6, 7, 8) according to claim 12, wherein
the holding unit (42, 43, 52, 62, 63, 72, 73) comprises a mechanism varying a rotation axis of any of rollers provided at the top face and the back face.

14. The roll-to-roll thin film coating machine (1, 2, 3, 4, 5, 6, 7, 8) according to any one of claims 11 to 13, wherein
the vacuum chambers comprises:
a first vacuum chamber (21) into which a first precursor gas is introduced;
a second vacuum chamber (22) into which a second precursor gas is introduced; and
a third vacuum chamber (23) into which a purge gas is introduced, the purge gas discharging the first precursors and the second precursors, wherein
the transfer mechanism (51, 61, 71, 81, 501, 1001) transfers the base member (15) to the first vacuum chamber (21) and, the second vacuum chamber (22), and the third vacuum chamber (23) multiple times.

## Patentansprüche

1. Rolle-zu-Rolle-Dünnfilmbeschichtungsmaschine (1, 2, 3, 4, 5, 6, 7, 8), Folgendes beinhaltend:
eine erste Vakuumkammer (21), in welche ein erstes Vorläufergas eingespeist wird;
eine zweite Vakuumkammer (22), in welche ein zweites Vorläufergas eingespeist wird;
eine dritte Vakuumkammer (23), in welche ein Spülgas eingespeist wird, wobei das Spülgas die ersten und die zweiten Vorläufer entlädt; und
eine Vielzahl von Transfermechanismen (51, 61, 71, 81, 501, 1001), welche ein wickelbares Basisglied (15) durch die erste Vakuumkammer (21), die zweite Vakuumkammer (22) und die dritte Vakuumkammer (23) transferieren, wobei die Transfermechanismen (51, 61, 71, 81, 501, 1001) eine Halterungseinheit (42, 43, 52, 62, 63, 72, 73) beinhalten, welche beide Endabschnitte des Basisgliedes (15) in einer Breitenrichtung hiervon hält, wobei die Transfermechanismen (51, 61, 71, 81, 501, 1001) das Basisglied (15) in die Lage versetzen, alternierend mehrfach durch die erste Vakuumkammer (21) und die zweite Vakuumkammer (22) zu passieren, wobei ein Atomlagenbeschichtungsfilm durch Auftragen eines Stapels von Atomlagen auf einer Fläche des Basisgliedes (15) gebildet wird, und ein jeder der Vielzahl von Transfermechanismen (51, 61, 71, 81, 501, 1001) unabhängig in einer Kammer aus der Gruppe, bestehend aus der ersten Vakuumkammer (21), der zweiten Vakuumkammer (22) und der dritten Vakuumkammer (23), vorhanden ist.

2. Rolle-zu-Rolle-Dünnfilmbeschichtungsmaschine (1, 2, 3, 4, 5, 6, 7, 8) nach Anspruch 1, bei welcher:
die Halterungseinheit (42, 43, 52, 62, 63, 72, 73) eine Sandwich-Halterungseinheit ist, welche beide Endabschnitte des Basisgliedes (15) in der Breitenrichtung hiervon hält.

3. Rolle-zu-Rolle-Dünnfilmbeschichtungsmaschine (1, 2, 3, 4, 5, 6, 7, 8) nach Anspruch 2, bei welcher:
die Sandwich-Halterungseinheit beide Endabschnitte des Basisgliedes (15) in der Breitenrichtung hiervon zwischen einer Vielzahl von Sandwich-Halterungsgliedern oder zwischen durchgängigen Sandwich-Halterungsgliedern in Sandwichmanier hält.

4. Rolle-zu-Rolle-Dünnfilmbeschichtungsmaschine (1, 2, 3, 4, 5, 6, 7, 8) nach Anspruch 2, bei welcher:
die Halterungseinheit (42, 43, 52, 62, 63, 72, 73) eine Stützeinheit ist, welche beide Endabschnitte des Basisgliedes (15) in der Breitenrichtung hiervon an einer Fläche des Basisgliedes (15) stützt.

5. Rolle-zu-Rolle-Dünnfilmbeschichtungsmaschine (1, 2, 3, 4, 5, 6, 7, 8) nach Anspruch 4, bei welcher:
das Basisglied (15) eine Vielzahl von Lochabschnitten an beiden Endabschnitten in Breitenrichtung hiervon besitzt, und
die Stützeinheit die Lochabschnitte durch Stützabschnitte stützt, die in diese passende hervorstehende Abschnitte besitzen.

6. Rolle-zu-Rolle-Dünnfilmbeschichtungsmaschine (1, 2, 3, 4, 5, 6, 7, 8) nach Anspruch 2, bei welcher:
die Sandwich-Halterungseinheit beide Endabschnitte des Basisgliedes (15) in der Breitenrichtung hiervon an einer Oberseite und einer Hinterseite zwischen einer Reihe von Rollen in Sandwichmanier hält, und mindestens eine der Rollen einen Antriebsmechanismus beinhaltet.

7. Rolle-zu-Rolle-Dünnfilmbeschichtungsmaschine (1, 2, 3, 4, 5, 6, 7, 8) nach Anspruch 6, bei welcher:
von den Rollen, diejenige Rolle, welche die Oberseite hält, oder diejenige Rolle, welche die Rückseite hält (502), einen Mechanismus beinhaltet, der in der Lage ist, eine Rotationsachse (501) zu variieren.

8. Rolle-zu-Rolle-Dünnfilmbeschichtungsmaschine (1, 2, 3, 4, 5, 6, 7, 8) nach einem der Ansprüche 1 bis 7, bei welcher:
der Transfermechanismus (51, 61, 71, 81, 501, 1001) so angeordnet ist, dass ein Bestandteil des Transfermechanismus (51, 61, 71, 81, 501, 1001) nicht durch die erste Vakuumkammer (21) und die zweite Vakuumkammer (22) passiert.

9. Rolle-zu-Rolle-Dünnfilmbeschichtungsmaschine (1, 2, 3, 4, 5, 5, 7, 8) nach einem der Ansprüche 1 bis 7, bei welcher:
eine Fläche des Bestandteils des Transfermechanismus (51, 61, 71, 81, 501, 1001) aus einem Material gebildet ist, das ein erstes Vorläufergas oder ein zweites Vorläufergas daran hindert, hieran chemisorbiert zu werden,

10. Rolle-zu-Rolle-Dünnfilmbeschichtungsmaschine (1, 2, 3, 4, 5, 6, 7, 8) nach einem der Ansprüche 1 bis 9, weiterhin beinhaltend:
eine Schutzschichtbildungseinheit, welche eine Schutzschicht an einer Fläche des in Atomlagen aufgetragenen Films bildet.

11. Rolle-zu-Rolle-Dünnfilmbeschichtungsmaschine (1, 2, 3, 4, 5, 6, 7, 8), Folgendes beinhaltend:
eine Vielzahl von Vakuumkammern (21, 22, 23), in welche zwei oder mehr Vorläufergase eingespeist werden; und
einen Transfermechanismus (51, 61, 71, 81, 501, 1001), der zum alternierenden, mehrfachen Transfer eines Basisgliedes (15) zu den Vakuumkammern (21, 22, 23) dient, und eine Halterungseinheit (42, 43, 52, 62, 63, 72, 73) beinhaltend, welche beide Endabschnitte des Basisgliedes in der Breitenrichtung hiervon durch Saugkraft hält; wobei
ein in Atomlagen aufgetragener Film durch Adsorption von Vorläufern an einer Fläche des Basisgliedes gebildet wird, wobei
der Transfermechanismus (51, 61, 71, 81, 501, 1001) aus einer Vielzahl von Rollen besteht,
Löcher an den Flächen der Rollen vorhanden sind; und
die Halterungseinheit (42, 43, 52, 62, 63, 72, 73) das Basisglied (15) durch Ansaugen des Basisgliedes (15) durch das Loch hält.

12. Rolle-zu-Rolle-Dünnfilmbeschichtungsmaschine (1, 2, 3, 4, 5, 6, 7, 8) nach Anspruch 11, bei welcher:
das Basisglied (15) eine Oberseite und eine Rückseite besitzt,
die Rollen an der Oberseite und an der Rückseite angeordnet sind,
mindestens eine der Rollen einen Antriebsmechanismus besitzt,
Löcher an einer Fläche von mindestens einer der Rollen an der Oberseite und der Rückseite angeordnet sind, und
die Halterungseinheit (42, 43, 52, 62, 63, 72, 73) das Basisglied (15) durch Ansaugen des Basisgliedes durch das Loch hält.

13. Rolle-zu-Rolle-Dünnfilmbeschichtungsmaschine (1, 2, 3, 4, 5, 6, 7, 8) nach Anspruch 12, bei welcher:
die Halterungseinheit (42, 43, 52, 62, 63, 72, 73) einen Mechanismus beinhaltet, welcher eine Rotationsachse einer der an der Oberseite und an der Rückseite vorhandenen Rollen variiert.

14. Rolle-zu-Rolle-Dünnfilmbeschichtungsmaschine (1, 2, 3, 4, 5, 6, 7, 8) nach einem der Ansprüche 11 bis 13, bei welcher:
die Vakuumkammern Folgendes beinhalten:
eine erste Vakuumkammer (21), in welche ein erstes Vorläufergas eingespeist wird;
eine zweite Vakuumkammer (22), in welche ein zweites Vorläufergas eingespeist wird;
und
eine dritte Vakuumkammer (23), in welche ein Spülgas eingespeist wird, wobei das Spülgas die ersten und die zweiten Vorläufer entlädt; wobei
der Transfermechanismus (51, 61, 71, 81, 501, 1001) das Basisglied (15) mehrfach zur ersten Vakuumkammer (21), zur zweiten Vakuumkammer (22) und zur dritten Vakuumkammer (23) transferiert.

## Revendications

1. Machine de revêtement de film mince du type rouleau à rouleau (1, 2, 3, 4, 5, 6, 7, 8) comprenant :
un premier compartiment sous vide (21) dans lequel un premier gaz précurseur est introduit ;
un deuxième compartiment sous vide (22) dans lequel un deuxième gaz précurseur est introduit ;
un troisième compartiment sous vide (23) dans lequel un gaz de purge est introduit, le gaz de purge déchargeant les premiers précurseurs et les deuxièmes précurseurs ; et
une pluralité de mécanismes de transfert (51, 61, 71, 81, 501, 1001) transférant un élément de base enroulable (15) à travers le premier compartiment sous vide (21), le deuxième compartiment sous vide (22) et le troisième compartiment sous vide (23), les mécanismes de transfert (51, 61, 71, 81, 501, 1001) comprenant une unité de retenue (42, 43, 52, 62, 63, 72, 73) retenant les deux parties d'extrémité de l'élément de base (15) dans une direction de la largeur de celui-ci, les mécanismes de transfert (51, 61, 71, 81, 501, 1001) permettant à l'élément de base (15) de passer alternativement à travers le premier compartiment sous vide (21) et le deuxième compartiment sous vide (22) plusieurs fois, formant ainsi un film déposé en couches atomiques en déposant une pile de couches atomiques sur une surface de l'élément de base (15), et chacun de la pluralité de mécanismes de transfert (51, 61, 71, 81, 501, 1001) étant prévu indépendamment dans l'un du premier compartiment sous vide (21), du deuxième compartiment sous vide (22) et du troisième compartiment sous vide (23).

2. Machine de revêtement de film mince du type rouleau à rouleau (1, 2, 3, 4, 5, 6, 7, 8) selon la revendication 1, dans laquelle l'unité de retenue (42, 43, 52, 62, 63, 72, 73) est une unité de retenue en sandwich retenant les deux parties d'extrémité de l'élément de base (15) dans la direction de la largeur de celui-ci.

3. Machine de revêtement de film mince du type rouleau à rouleau (1, 2, 3, 4, 5, 6, 7, 8) selon la revendication 2, dans laquelle l'unité de retenue en sandwich prend en sandwich les deux parties d'extrémité de l'élément de base (15) dans la direction de la largeur de celui-ci entre une pluralité d'éléments de retenue en sandwich ou entre des éléments de retenue en sandwich continus.

4. Machine de revêtement de film mince du type rouleau à rouleau (1, 2, 3, 4, 5, 6, 7, 8) selon la revendication 2, dans laquelle l'unité de retenue en sandwich (42, 43, 52, 62, 63, 72, 73) est une unité de support supportant les deux parties d'extrémité de l'élément de base (15) dans la direction de la largeur de celui-ci au niveau d'une surface de l'élément de base (15).

5. Machine de revêtement de film mince du type rouleau à rouleau (1, 2, 3, 4, 5, 6, 7, 8) selon la revendication 4, dans laquelle l'élément de base (15) a une pluralité de parties perforées au niveau des deux parties d'extrémité dans la direction de la largeur de celui-ci, et
l'unité de support supporte les parties perforées par des parties de support ayant des parties saillantes s'y insérant.

6. Machine de revêtement de film mince du type rouleau à rouleau (1, 2, 3, 4, 5, 6, 7, 8) selon la revendication 2, dans laquelle l'unité de retenue en sandwich prend en sandwich les deux parties d'extrémité de l'élément de base (15) dans la direction de la largeur de celui-ci au niveau d'une face supérieure et d'une face arrière entre une pluralité de rouleaux, et
au moins l'un des rouleaux comprend un mécanisme d'entraînement.

7. Machine de revêtement de film mince du type rouleau à rouleau (1, 2, 3, 4, 5, 6, 7, 8) selon la revendication 6, dans laquelle parmi les rouleaux le rouleau retenant la face supérieure ou le rouleau retenant la face arrière (502) comprend un mécanisme capable de faire varier un axe de rotation (501).

8. Machine de revêtement de film mince du type rouleau à rouleau (1, 2, 3, 4, 5, 6, 7, 8) selon l'une quelconque des revendications 1 à 7, dans laquelle le mécanisme de transfert (51, 61, 71, 81, 501, 1001) est positionné de sorte qu'une pièce constituant le mécanisme de transfert (51, 61, 71, 81, 501, 1001) ne passe pas à travers le premier compartiment sous vide (21) et le deuxième compartiment sous vide (22).

9. Machine de revêtement de film mince du type rouleau à rouleau (1, 2, 3, 4, 5, 6, 7, 8) selon l'une quelconque des revendications 1 à 7, dans laquelle une surface de la pièce constituant le mécanisme de transfert (51, 61, 71, 81, 501, 1001) est formée par un matériau qui est capable d'empêcher un premier gaz précurseur ou un deuxième gaz précurseur d'être chimisorbé dessus.

10. Machine de revêtement de film mince du type rouleau à rouleau (1, 2, 3, 4, 5, 6, 7, 8) selon l'une quelconque des revendications 1 à 9, comprenant en outre :
une unité de formation de couche de protection formant une couche de protection sur une surface du film déposé en couches atomiques.

11. Machine de revêtement de film mince du type rouleau à rouleau (1, 2, 3, 4, 5, 6, 7, 8) comprenant :
une pluralité de compartiments sous vide (21, 22, 23) dans lesquels deux gaz précurseurs ou plus sont introduits ; et
un mécanisme de transfert (51, 61, 71, 81, 501, 1001) utilisé pour transférer un élément de base (15) aux compartiments sous vide (21, 22, 23) en alternance plusieurs fois et comprenant une unité de retenue (42, 43, 52, 62, 63, 72, 73) retenant les deux parties d'extrémité de l'élément de base dans la direction de la largeur de celui-ci par aspiration, dans laquelle
un film déposé en couches atomiques est formé en adsorbant des précurseurs sur une surface de l'élément de base, dans laquelle
le mécanisme de transfert (51, 61, 71, 81, 501, 1001) est constitué par une pluralité de rouleaux,
des trous sont ménagés sur des surfaces des rouleaux, et
l'unité de retenue (42, 43, 52, 62, 63, 72, 73) retient l'élément de base (15) en aspirant l'élément de base (15) à travers le trou.

12. Machine de revêtement de film mince du type rouleau à rouleau (1, 2, 3, 4, 5, 6, 7, 8) selon la revendication 11, dans laquelle
l'élément de base (15) a une face supérieure et une face arrière,
les rouleaux sont agencés au niveau de la face supérieure et de la face arrière,
au moins l'un des rouleaux comprend un mécanisme d'entraînement,
des trous sont ménagés sur une surface d'au moins l'un des rouleaux agencés au niveau de la face supérieure et de la face arrière, et
l'unité de retenue (42, 43, 52, 62, 63, 72, 73) retient l'élément de base (15) en aspirant l'élément de base à travers le trou.

13. Machine de revêtement de film mince du type rouleau à rouleau (1, 2, 3, 4, 5, 6, 7, 8) selon la revendication 12, dans laquelle l'unité de retenue (42, 43, 52, 53, 62, 63, 72, 73) comprend un mécanisme faisant varier un axe de rotation de l'un quelconque des rouleaux ménagés au niveau de la face supérieure et de la face arrière.

14. Machine de revêtement de film mince du type rouleau à rouleau (1, 2, 3, 4, 5, 6, 7, 8) selon l'une quelconque des revendications 11 à 13, dans laquelle les compartiments sous vide comprennent :
un premier compartiment sous vide (21) dans lequel un premier gaz précurseur est introduit ;
un deuxième compartiment sous vide (22) dans lequel un deuxième gaz précurseur est introduit ;
et
un troisième compartiment sous vide (23) dans lequel un gaz de purge est introduit, le gaz de purge déchargeant les premiers précurseurs et les deuxièmes précurseurs, dans laquelle
le mécanisme de transfert (51, 61, 71, 81, 501, 1001) transfère l'élément de base (15) au premier compartiment sous vide (21) et au deuxième compartiment sous vide (22) et au troisième compartiment sous vide (23) plusieurs fois.
